# EUROPEAN PATENT SPECIFICATION

(11) **EP 4 660 644 B1**
(45) Date of publication and mention of the grant of the patent: **28.10.2026**
(21) Application number: 25180193.2
(22) Date of filing: 02.06.2025
(51) Int. Cl.: H03K 17/18, H03K 17/082, G01R 31/327, H03K 17/12

(54) **A METHOD FOR DETECTING THE HEALTH OF A FIRST SWITCHING UNIT OF A POWER SYSTEM AND POWER SYSTEM**
VERFAHREN ZUR ERKENNUNG DES ZUSTANDS EINER ERSTEN SCHALTEINHEIT EINES STROMVERSORGUNGSSYSTEMS UND STROMVERSORGUNGSSYSTEM
PROCÉDÉ DE DÉTECTION DE L'ÉTAT D'UNE PREMIÈRE UNITÉ DE COMMUTATION D'UN SYSTÈME D'ALIMENTATION ET SYSTÈME D'ALIMENTATION

(30) Priority: 05.06.2024 GB 202407965
(43) Date of publication of application: 10.12.2025
(73) Proprietor: Rolls-Royce Deutschland Ltd & Co KG, 15827 Blankenfelde-Mahlow (DE)
(72) Inventor: GAJANAYAKE, Chandana, 15827 Blankenfelde-Mahlow (DE); MOHAMED HALICK, Mohamed Sathik, 15827 Blankenfelde-Mahlow (DE); HO, Anh Vu, 15827 Blankenfelde-Mahlow (DE)

(56) References cited:
- EP-A2- 2 720 053
- WO-A1-2024/089430
- US-A1- 2009 212 975

## Description

### FIELD

The present disclosure relates a method for detecting the health of a first switching unit of a power system and a corresponding power system.

### BACKGROUND

With increased penetration of electrical systems and the progression towards full electric and hybrid propulsion systems, the use of energy storage systems and DC power distribution has gained increased use. Multiple loads and sources may be connected to a DC distribution system such as a hybrid propulsion system. In such systems, power converters such as inverters, rectifiers and DC/DC converters are needed for interfacing electrical propulsion motors, turbo generators, fuel cells and battery energy storage systems. Further, in such systems, adequate DC protection devices are required. Due to the fact that SSPCs (Solid State Power Controllers, also referred to a Solid State Circuit Breakers) show a fast response time, eliminate arcing during turn-off, and have a high reliability, SSPCs are preferred over electro-mechanical switches.

All such devices (power converters, DC/DC converters, SSPCs) include switching units, wherein it is known to connect in a switching unit several semiconductor switches such as MOSFETs in parallel. However, when a number of parallel semiconductor switches is used, there is a risk that failure of one or several semiconductor switches leads to failure or shutdown of the complete device, and the device may need to be replaced or serviced. There is thus a desire to get a clear understanding of the status and health of the device and its semiconductor switches.

There is a need to provide a method that allows to determine the health of semiconductor switches arranged in parallel in a switching unit of a power system and a corresponding power system. WO 2024/089430 A1 is known from the prior art and discloses a switching unit for a power control unit, comprising an electrical current path with a plurality of switches between a power supply node and a load node. Each switch can be independently controlled between an open-circuit state and a closed-circuit state thus modifying the continuity of the current path; the switches can be to be set into either of a parallel configuration or a series configuration with respect to the electrical current path. The failure state of a given first switch in a short-circuit case (if current continues to pass after one or more switches have been triggered to turn off,) is determined by measuring the drain to source voltage (i.e. VDS) across the switch, and determining if this is in the expected range based on a predefined control voltage (i.e. VGS) applied to the gate of the respective switch.

### SUMMARY

In a first aspect a method for detecting the health of a first switching unit of a power system is provided. The first switching unit comprises a plurality of first semiconductor switches arranged in parallel, wherein the power system further comprises at least one further switching unit, and wherein the first switching unit and the further switching unit are arranged in a current path such that a current passes through them when both are switched on. In such power system, the method comprises the steps of: switching off the first parallel **semiconductor** switches of the first switching unit and switching off the further switching unit; switching on the further switching unit in a pulsed manner; determining if there is a current flow between the switched off first parallel semiconductor switches and the further switching unit, wherein a current flow indicates a short circuit fault condition of the first switching unit; and if there is a current flow, determining the number of short-circuited first semiconductor switches in the first switching unit by measuring the on-state voltage over the plurality of first semiconductor switches and comparing the measured on-state voltage with at least one of N predetermined threshold voltages over the plurality of first semiconductor switches which differ dependent on the number of short-circuited first semiconductor switches, wherein M ≥ N ≥ 2, M is the number of first semiconductor switches and N is a natural number.

Aspects of the invention are thus based on the idea to provide for a method that allows to determine if and how many of the parallel semiconductor switches of a switching unit have experienced a short-circuit fault condition. Once such information is available, specific measures can be implemented such as replacing the switching unit or servicing of the switching unit by burning the short-circuited semiconductor switches.

To determine if one or several of the parallel semiconductor switches have experienced a short-circuit condition, initially the parallel semiconductor switches of the considered first switching unit and also the further switching unit are switched off. As mentioned, the further switching unit is a switching unit of the power system which is arranged such that a current passes through the first switching unit and the further switching unit when both are switched on. The further switching unit may comprise a semiconductor switch or several semiconductor switches arranged in parallel.

Subsequently, the further switching unit is switched on in a pulsed manner. It is then determined if there is a current flow between the switched off first semiconductor switches and the further switching unit. In case there are no short-circuited first semiconductor switches, there is no current flow, as all first semiconductor switches are switched off. Only if one or several of the first semiconductor switches are short-circuited, there is a current flow due to the short-circuit condition between the switched off first semiconductor switches and the further switching unit. Accordingly, the presence of a current flow indicates a short circuit fault condition of the first switching unit, namely, of one or several of the parallel first semiconductor switches of the first switching unit.

However, the presence of a current flow does not include information of how many of the first semiconductor switches are short-circuited. To determine the number of short-circuited first semiconductor switches, aspects of the invention further measure the on-state voltage over the plurality of first semiconductor switches and compare the measured on-state voltage with at least one of N predetermined threshold voltages over the plurality of first semiconductor switches, wherein the N predetermined threshold voltages differ dependent on the number of short-circuited first semiconductor switches. This aspect is based on the realization that, the more of the parallel first semiconductor switches are short-circuited, the higher is the on-state voltage over the plurality of first semiconductor switches (i.e., over all semiconductor switches of the first switching unit). In other words, as the on-state voltage increases with the number of short-circuited first semiconductor switches, the number of short-circuited semiconductor switches can be determined by comparing the measured on-state voltage with predetermined threshold voltages which correspond to on-state voltages which are present when one, two, three, etc. of the first semiconductor switches are short-circuited.

In this respect, the following applies regarding the number N of predetermined threshold voltages: M ≥ N ≥ 2, wherein M is the number of first semiconductor switches and N is a natural number. For example, if there are two parallel first semiconductor switches, a measured on-state voltage is compared with up to two predetermined threshold voltages. In another example, if there are six parallel first semiconductor switches, a measured on-state voltage may be compared with up to two, three, three, four or five predetermined threshold voltages, while it may be preferable in embodiments to choose N to be equal to M.

The method is easy to implement as all that is required is to additional measure the on-state voltage over the first semiconductor switches.

It is pointed out that as on-state voltage is understood the on-state drain-source voltage of the semiconductor switch (or the collector-emitter voltage in case of bipolar or IGBT semiconductor switches), wherein "on-state" means that the control terminal (gate or base) of the semiconductor switch is provided with a voltage such that the semiconductor switch is switched on and able to guide a current.

In some embodiments, a first predetermined threshold voltage Vdsₜₕ₁ refers to an on-state voltage over the plurality of first semiconductor switches which is present when one of the plurality of first semiconductor switches is in a short-circuited state. Further, an Nth predetermined threshold voltage Vds_{thN} refers to an on-state voltage over the plurality of first semiconductor switches which is present when N of the plurality of first semiconductor switches are in a short-circuited state. With such threshold voltages, determining the number of short-circuited first semiconductor switches in the first switching unit comprises: determining if the measured on-state voltage Vdsₘ is smaller than the first predetermined threshold voltage Vdsₜₕ₁ and, if so, further determining that one of the first semiconductor switches is short-circuited (wherein the method ends here); if not, determining if the measured on-state voltage Vdsₘ is smaller than the second predetermined threshold voltage Vdsₜₕ₂ and, if so, further determine that two of the first semiconductor switches are short-circuited (wherein the method ends here); and as long as the number of short-circuited first semiconductor switches has not been determined, repeat the comparison up to the Nth predetermined threshold voltage Vds_{thN}, wherein with the Nth predetermined threshold voltage Vds_{thN} it is determined if the measured on-state voltage Vdsₘ is smaller than the Nth predetermined threshold voltage Vds_{thN} and, if so, it is further determined that N of the first semiconductor switches are short-circuited.

Such a method is thus based on the idea to check if the measured on-state voltage is smaller than the first threshold voltage. If this is the case, it is deducted that one semiconductor switch is short-circuited (as on-state voltage increases with each semiconductor switch that is short-circuited). If this is not the case, it is checked if the measured on-state voltage is smaller than the second threshold voltage. If this is the case, it is deducted that two semiconductor switches are short-circuited. The process continues with checking if the measured on-state voltage is smaller than the third, fourth, fifth, etc., Nth threshold voltage. If the measured on-state voltage is smaller than the respective threshold voltage, it can be deducted that the corresponding number of semiconductor switches is short-circuited. The method ends with comparing the measured on-state voltage with the Nth threshold voltage, if the number of short-circuited first semiconductor switches has not been determined before.

As discussed, it is initially determined if there is a current flow between the switched off first parallel semiconductor switches and the further switching unit. Such determination may be made in a plurality of manners, i.e., by measuring a current flow through the further switching unit.

In some embodiments, the determination if there is a current flow between the switched off first parallel semiconductor switches and the further switching unit is based on a voltage measurement over the first semiconductor switches, which is convenient as such measurement is made anyway within the method. In such embodiment, the determination comprises: switching on the first parallel semiconductor switches of the first switching unit and switching on the further switching unit in a pulsed manner; measuring the on-state voltage Vdsₘ over the plurality of first semiconductor switches during the applying of pulses; comparing the measured on-state voltage Vdsₘ of the plurality of first semiconductor switches with a predetermined healthy state threshold voltage Vdsₜₕ, wherein the predetermined healthy state threshold voltage Vdsₜₕ refers to an on-state voltage present when all of the plurality of first semiconductor switches are in a healthy state; and determining if the measured on-state voltage Vdsₘ is larger than the predetermined healthy state threshold voltage Vdsₜₕ.

Accordingly, in such embodiment, the measured on-state voltage over the first semiconductor switches is compared with a "healthy state" threshold voltage which is defined by the state in which all of the parallel first semiconductor switches are in a healthy state. As the on-state voltage over the first semiconductor switches increases if one or several of the first semiconductor switches are short-circuited, by comparing the respective voltages the presence of a current flow between the switched off first parallel semiconductor switches and the further switching unit can be determined indirectly in an efficient manner.

In some embodiments, depending on the number of short-circuited first semiconductor switches, the first switching unit may be fully replaced. In such embodiment, the knowledge achieved through the inventive method about the number of short-circuited first semiconductor switches is used to determine the health of the first switching unit, wherein the first switching unit is replaced if the health is below a determined level, i.e., if the number of short-circuited semiconductor switches is larger than a predetermined number of allowed short-circuited semiconductor switches.

In some embodiments, after determining the number of short-circuited first semiconductor switches in accordance with the invention, a current is guided through only the short-circuited first semiconductor switches of the first switching unit and through the further switching unit to burn the short-circuited first semiconductor switches (or series fuses respectively arranged in series with the short-circuited semiconductor switches), wherein the current is dependent on the number of short-circuited first semiconductor switches. In such embodiment, a current is provided that flows through the one or several short-circuited semiconductor switches only (and not through the healthy first semiconductor switches) and thus burns the short-circuited semiconductor switches or an element arranged in series with the short-circuited semiconductor switch, thereby removing the short-circuited semiconductor switches from the switching unit without damaging the other components in the system.

The knowledge about the number of short-circuited semiconductor switches is valuable to determine the current required to burn the short-circuited semiconductor switches. For example, the number of short-circuited semiconductor switches may determine the length of pulses that switch on the further switching unit.

In some embodiments, the N predetermined threshold voltages are predetermined based on information provided by the manufacturer of the semiconductor switches. Accordingly, for example, a datasheet of the like of the semiconductor switches is consulted to determine the on-state resistance of a single semiconductor switch. Such knowledge together the rules governing the voltage for parallel connection of resistors (the semiconductor switches act as resistors in the on-state) allows to determine the on-state voltage over the plurality of parallel first semiconductor switches.

In some embodiments, it is further determined another possible fault of the first semiconductor switches, namely, an open circuit condition of the first semiconductor switches, wherein in the open circuit condition the semiconductor switch does not guide current even if the semiconductor switch is switched on. Such fault determination is made by initially determining the on-state resistance Rdsₘ of the first switching unit (i.e., the on-state resistance Rdsₘ of the parallel first semiconductor switches). The on-state resistance Rdsₘ is determined based on the measured on-state voltage Vdsₘ (using Ohm's law at a given current).

Subsequently, to determine the number of open-circuited first semiconductor switches in the first switching unit, the on-state resistance Rdsₘ of the first switching unit is compared with least one of N predetermined resistance threshold values which differ dependent on the number of open-circuited first semiconductor switches, wherein M ≥ N ≥ 2, M is the number of first semiconductor switches and N is a natural number.

The procedure is similar to the procedure when comparing the measured on-state voltage with specific thresholds to determine how many of the first semiconductor switches are short-circuited.

More particularly, a first predetermined resistance threshold value Rdsₜₕ₁ refers to an on-state resistance present when one of the plurality of first semiconductor switches is in an open-circuit state, and an Nth predetermined resistance threshold value Rds_{thN} refers to an on-state resistance present when N of the plurality of first semiconductor switches are in open-circuit state. With such resistance threshold values, determining the number of first semiconductor switches with an open circuit for in the first switching unit comprises: determining if the on-state resistance Rdsₘ is smaller than the first predetermined resistance threshold value Rdsₜₕ₁ and, if so, further determining that one of the first semiconductor switches is open-circuited; if not, determining if the measured on-state resistance Rdsₘ is smaller than the second predetermined resistance threshold value Rdsₜₕ₂ and, if so, further determining that two of the first semiconductor switches are open-circuited; as long as the number of open-circuited first semiconductor switches has not been determined, repeating the comparison up to the Nth predetermined resistance threshold value Rds_{thN}, wherein with the Nth predetermined resistance threshold value Rds_{thN} it is determined if the on-state resistance Rdsₘ is smaller than the Nth predetermined resistance threshold value Rds_{thN} and, if so, it is further determined that N of the first semiconductor switches are open-circuited.

Such a method is thus based on the idea to check if the measured on-state resistance is smaller than the first predetermined resistance threshold value. If this is the case, it is deducted that one semiconductor switch is open-circuited. If this is not the case, it is checked if the measured on-state resistance is smaller than the second predetermined resistance threshold value. If this is the case, it is deducted that two semiconductor switches are open-circuited. The process continues with checking if the measured on-state resistance is smaller than the third, fourth, fifth, etc., Nth predetermined resistance threshold value. If the measured on-state resistance is smaller than the respective predetermined resistance threshold value, it can be deducted that the corresponding number of semiconductor switches is open-circuited. The method ends with comparing the measured on-state resistance with the Nth predetermined resistance threshold value, if the number of open-circuited first semiconductor switches has not been determined before.

In such embodiment, the on-state resistance of the first switching unit may be determined from the measured on-state voltage using the formula ${Rds}_{m} \left(t\right) = {Vds}_{m} \left(t\right) / {i}_{d} \left(t\right)$ wherein Rdsₘ (t) the on-state resistance of the first switching unit; Vdsₘ (t) is the on-state voltage over the first switching unit; and i_{d} (t) is the current through the first switching unit.

In some embodiments, a pre-determined continuous stream of pulses is applied to a control terminal of the further switching unit when switching on the further switching unit in a pulsed manner. The further switching unit thus may be operated such that a pre-determined continuous stream of pulses is applied. By applying pulses, the current through the further switching unit can be controlled without damaging the further switching unit (which may be damaged if a short-circuit current is present for a longer period of time).

The applied continuous pulsed stream may follow a high-frequency pulse pattern. The pulses may be pulse-width modulated. The further switching unit may comprise one or several semiconductor switches and the pulses may be applied to one or several control terminals of the semiconductor switches of the further switching unit by driver signals of a gate driver. By means of a continuous stream of pulses, a pulsed current is created.

In some embodiments, the first parallel semiconductor switches of the first switching unit are controlled by a single (common) gate driver. This is convenient as the number of gate drivers can be limited in this way. However, alternatively, the semiconductor switches may be driven by individual gate drivers instead.

Generally, the semiconductor switches each comprise a control terminal (such as a Gate-Terminal in case of a MOSFET) which is controlled by a common or individual gate driver.

It is pointed out that measuring the on-state voltage over the plurality of first semiconductor switches does not necessarily need to be carried out by a separate/additional measurement unit. In embodiments, the on-state voltage over the plurality of first semiconductor switches may be detected indirectly from other voltage and/or resistance and/or current values. For example, the on-state voltage may be **determined** by monitoring phase current, DC link voltage and phase-to-phase voltage of a power system.

In a further aspect of the present invention, a power system is provided for. The power system comprises a power bus with a first voltage rail and a second voltage rail (which may be a positive voltage rail and a negative voltage rail), a first switching unit arranged in the first voltage rail or the second voltage rail, wherein the first switching unit comprises a plurality of first semiconductor switches arranged in parallel. The power system further comprises at least one further switching unit, wherein the first switching unit and the further switching unit are configured and arranged in the power system such that a current path passes through them when both are switched on. There is also provided a voltage measurement unit configured to measure the on-state voltage Vdsₘ over the plurality of first semiconductor switches, and a controller. The controller is configured to: switch off the first parallel semiconductor switches of the first switching unit and switch off the further switching unit; switch on the further switching unit in a pulsed manner; determine if there is a current flow between the switched off first parallel semiconductor switches and the further switching unit, wherein a current flow indicates a short circuit fault condition of the first switching unit; and if there is a current flow, determine the number of short-circuited first semiconductor switches in the first switching unit by measuring the on-state voltage (Vdsₘ) over the plurality of first semiconductor switches by means of the voltage measurement unit and compare the measured on-state voltage (Vdsₘ) with at least one of N predetermined threshold voltages over the plurality of first semiconductor switches which differ dependent on the number of short-circuited first semiconductor switches, wherein M ≥ N ≥ 2, M is the number of first semiconductor switches and N is a natural number.

Embodiments of the power system correspond to the above discussed embodiments of the method of the present disclosure.

Generally, the first semiconductor switches may be MOSFET, IGBT, GaN or SiC transistors in embodiments.

In some embodiments, each of the first semiconductor switches may be arranged in combination with an antiparallel diode. Such diodes give current that flows in the opposite direction a path to flow, thereby avoiding high voltage peaks eventually caused by inductive currents.

In further embodiments, the at least one further switching unit is an element of a solid state power controller, DC/DC converter or power converter, wherein the first switching unit is also an element of such solid state power controller, DC/DC converter or power converter. In all such embodiments, there is a desire to know the health of the first switching unit and of its parallel semiconductor switches. The further switching unit is used to create a current flow to detect a fault within the parallel semiconductor switches in accordance with the described methods. The further switching unit may also be used to service a short-circuited semiconductor switch by burning it by allowing a current to flow through the short-circuited semiconductor switch and the further switching unit. The at least one further switching unit may be an additional auxiliary switching unit in case of a solid state power controller or may be part of a specific leg in a DC/DC converter or three phase inverter.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DRAWINGS

The invention will be explained in more detail on the basis of exemplary embodiments with reference to the accompanying drawings in which:
FIG. 1 is an embodiment of a DC power system that implements an SSPC, wherein the SSPC includes first and second switching units which each comprise a plurality of semiconductor switches arranged in parallel, and wherein further an auxiliary switching unit is provided that allows to guide a short-circuit current through a faulty semiconductor switch to burn and remove the faulty semiconductor switch;
FIG. 2 shows a variant of the embodiment of FIG. 1, wherein the first switching unit of FIG. 1 is considered, and wherein additionally a voltage measurement unit is provided that allows to measure the voltage over the plurality of semiconductor switches of the first switching unit;
FIG. 3 is a flowchart of a method for detecting the health of a first switching unit of a power system, wherein the number of short-circuited semiconductor switches is determined;
FIG. 4A is a flowchart of a more detailed method for detecting the health of a first switching unit of a power system, wherein the number of short-circuited semiconductor switches is determined;
FIG. 4B is the continuation of the flowchart of FIG. 4A;
FIG. 5A is a flowchart of a another more detailed method for detecting the health of a first switching unit of a power system, wherein both the number of short-circuited semiconductor switches and the number of open-circuited semiconductor switches can be determined;
FIG. 5B is the continuation of the flowchart of FIG. 5A;
FIG. 6 is an embodiment of a DC power system that implements a DC/DC converter that comprises four switching units arranged in two legs, each leg having a top switching unit and a bottom switching unit, wherein each of the switching units comprises a plurality of semiconductor switches arranged in parallel, and wherein in case one of the semiconductor switches has a fault a current is guided through the faulty semiconductor switch and the semiconductor switches of the one of the switching units of the other leg to burn of the faulty semiconductor switch;
FIG. 7 is an embodiment of a power system that implements a power converter that comprises six switching units arranged in three legs, each leg having a top switching unit and a bottom switching unit, wherein each of the switching units comprises a plurality of semiconductor switches arranged in parallel, and wherein in case one of the semiconductor switches has a fault a current is guided through the faulty semiconductor switch and two of the other switching units to burn of the faulty semiconductor switch; and
FIG. 8 is a variant of the embodiment of FIG. 7, wherein additionally an evaluation unit is provided for determining the on-state voltage of the switching units of the power system of FIG. 7.

### DETAILED DESCRIPTION

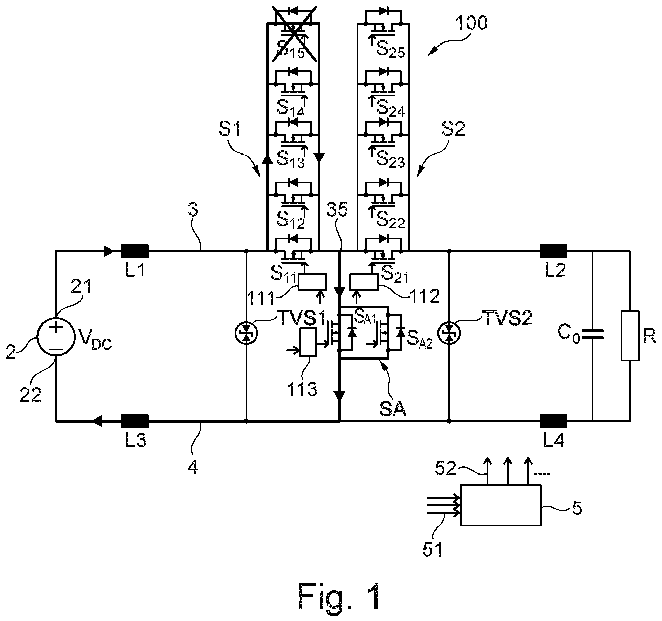

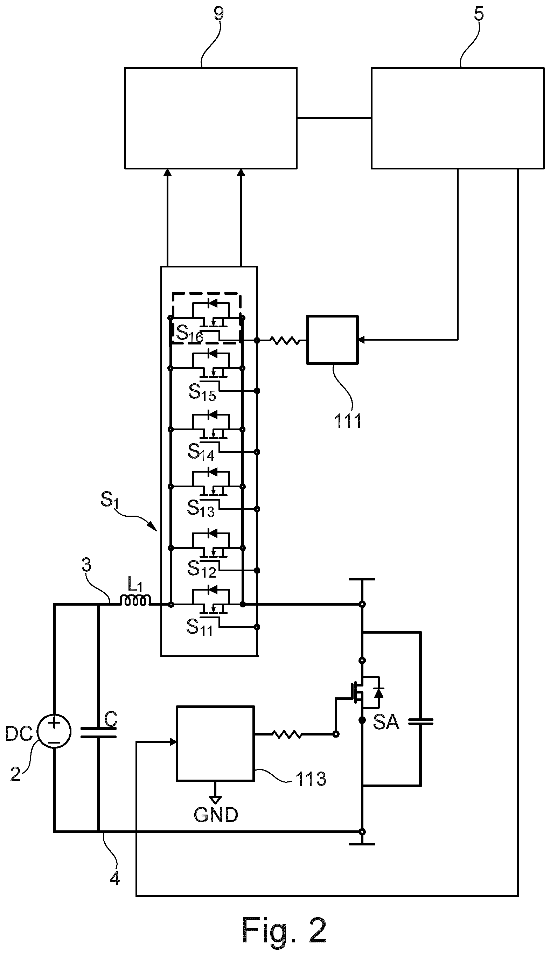

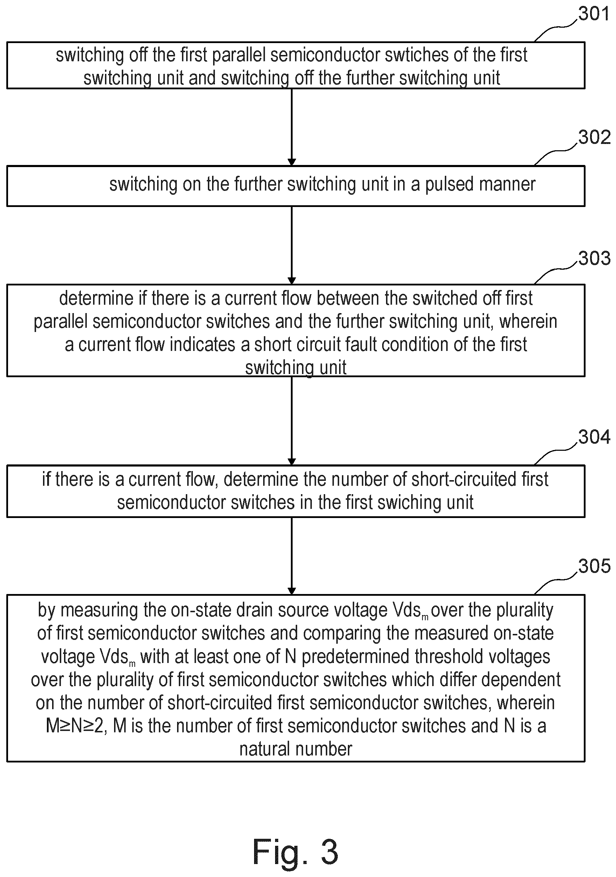

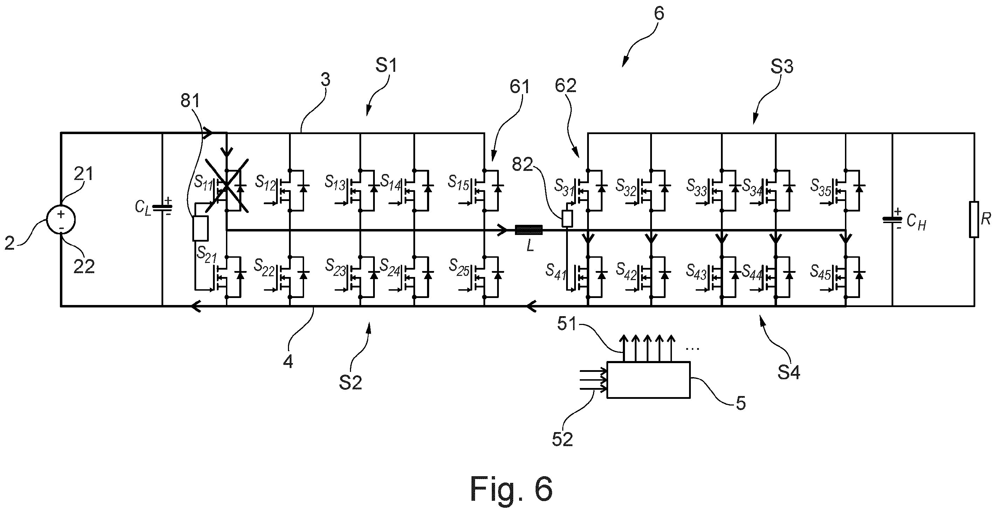

To give an overview of the subsequent description, an example environment in which the method of the present invention may be carried out it is initially discussed with respect to FIG. 1. FIG. 2 highlights specific features in such example environment which are helpful to carry out the method. FIGS. 3 to 5 show different example methods. FIGS. 6 to 8 show further example environments in which the method of the present invention may be carried out.

FIG. 1 depicts a power system that comprises a DC power source 2 having a positive terminal 21 and a negative terminal 22, a power bus having a positive voltage rail 3 and a negative voltage rail 4, a bidirectional solid state power controller (SSPC) 100, a load R, a capacitive load C₀, and several inductances L1-L4, wherein inductances L1, L2 are arranged in the positive voltage rail 3 and inductances L3, L4 are arranged in the negative voltage rail 4.

The SSPC 100 comprises two switching units S1, S2, wherein each of the switching units comprises of a plurality of semiconductor switches S11-S15, S21-S25 which are arranged in parallel. Each of the semiconductor switches S11-S15, S21-S25 comprises a transistor and an antiparallel bypass diode that gives current that flows in the opposite direction a path to flow. Without the diodes, inductive currents would cease instantly, generating high voltage peaks. The SSPC 100 further comprises two gate drivers 111, 112 for the semiconductor switches S11-S15, S21-S25 of the first and second switching units S1, S2 which control the respective gate voltage. It is pointed out that the gate drivers 111, 112 are depicted schematically only. In another embodiment, there may be provided individual gate drivers for the individual semiconductor switches S11-S15, S21-S25. The SSPC 100 may further comprise a microcontroller (not shown) for logic control.

The semiconductor switches S11-S15, S21-S25 may be MOSFET (metal-oxide-semiconductor field-effect transistor), GaN (Gallium Nitride), SiC (Silicon Carbide) or IGBT (Insulated Gate Bipolar Transistor) switches.

Alternative to having two switching units S1, S2, a unidirectional SSPC with a single switching unit S1 may implemented.

Further, it is pointed out that switching units may be additionally or alternatively be implemented in the negative voltage rail 4.

It is further pointed out that the number of five parallel semiconductor switches in the switching units S1, S2 is to be understood as an example only. The number of parallel devices is determined by the current requirements of the SSPC 100.

By paralleling a plurality of semiconductor switches S11-S15, S21-S25 in the switching units S1, S2, current capacity can be increased and/or voltage drop and power loss can be reduced. However, switching devices may fail due to multiple reasons, such as overvoltage, EMI, high dv/dt, unequal current sharing, manufacturing defects, etc. With a large number of parallel semiconductor switches, there is an increased risk that failure of a single semiconductor switch can lead to failure of the complete SSPC 100 or require shutdown of the complete SSPC 100, this leading to a disruption of the system.

To address this problem, the DC power system of FIG. 1 implements further components which allow to service the DC power system by removing a faulty semiconductor switch without damaging the other semiconductor switches.

To implement such function, the DC power system further comprises an auxiliary switching unit SA which is arranged between the positive voltage rail 3 and the negative voltage rail 4. More particularly, the auxiliary switching unit SA is arranged such that it is connected with one terminal to the negative voltage rail 4 and with another other terminal to the positive voltage rail 3, wherein the connection to the positive voltage rail 3 is such that the connection is at a point 35 between the first and second switching units S1, S2. Thereby, current guided through the auxiliary switching unit SA may be directed either through the switching unit S1 or the switching unit S2.

The depicted embodiment, the auxiliary switching unit SA comprises two parallel semiconductor switches SA1, SA2, but this is to be understood as an example only. Alternatively, there may be a single semiconductor switch or more than two semiconductor switches. Each semiconductor switch SA1, SA2 comprises a transistor (such as MOSFET) and a bypass diode. A gate driver 113 is provided which drives the gates of the semiconductor switches SA1, SA2. The gate driver 113 may be a separate gate driver or be integrated into a common gate driver. Also, individual gate drivers for switches SA1, SA2 may be provided for.

Further, a controller 5 is provided which is depicted schematically. The controller 5 is configured to receive or determine information if one or several of the semiconductor switches S11-S15, S21-S25 has a fault condition through input lines 51. Examples of how such information may be determined by controller 5 will be described with respect to FIGS. 3 to 5.

In case a fault condition is detected, the controller 5 is further configured to control the respective switching unit S1, S2 and the auxiliary switching unit SA such that a short-circuit current flows through the auxiliary switching unit SA. It automatically also flows through a faulty semiconductor switch as the semiconductor switches are switched off such that there is current flow through a faulty semiconductor switch only. For example, as indicated in FIG. 1, semiconductor switch S15 of switching unit S1 may have experienced a short-circuit condition. Accordingly, it has to be removed to allow further operation of the SSPC 100. To this end, the auxiliary semiconductor switches SA1 and SA2 are switched ON, thereby providing a short-circuit current between the positive voltage rail 3 and the negative voltage rail 4.

At the same time, in switching unit S1 semiconductor switches S11 to S15 are switched OFF such that the current passes the short-circuited semiconductor switch S15 only. To achieve this, the controller 5 provides respective control signals 52 to the gate driver 111 through output lines 52. Accordingly, the short-circuit current is guided through auxiliary semiconductor switches SA1 and SA2 and the faulty semiconductor switch S15 only. FIG. 1 indicates the direction and path of the short-circuit current. As the short-circuit current is concentrated on the faulty semiconductor switch S15, the faulty semiconductor switch S15 is burned by the short-circuit and, thereby, removed from the switching unit. In particular, a previous short-circuit of the semiconductor switch S15 is transformed by the burning into an open state of the semiconductor switch S15.

The controller 5 may comprise a processor for executing instructions and a memory which is coupled to the processor and in which instructions are stored which, when executed by the processor, cause the processor to perform said functions of receiving information about the semiconductor switches and controlling the auxiliary switching unit and the semiconductor switches. The controller 5 may be a separate unit or may be integrated into a common gate driver or one of the gate drivers 111, 112, 113 or may be integrated into a microcontroller of the SSPC 100. Also, the controller 5 may communicate with other control devices of the system.

When providing for a short-circuit to remove the faulty semiconductor switch in the above embodiment, the controller 5 controls the auxiliary switching unit SA such that a pre-determined continuous stream of pulses is applied when a fault condition is present. This allows the semiconductor switch to be blown off safely without damaging the auxiliary semiconductor switches SA1, SA2. The continuous pulse stream may be pre-determined dependent, among others, on the number of short-circuited semiconductor switch

As already mentioned, alternative to having two switching units S1, S2, a unidirectional SSPC with a single switching unit S1 may be implemented. Such embodiment is depicted in FIG. 2, wherein a first switching unit S1 with six parallel semiconductor switches S11 to S16 is shown. Similar as in FIG. 1, there is provided a controller 5 providing control signals to a gate driver 111 for the semiconductor switches S11 to S16 and to a gate driver 113 for the auxiliary switching unit SA. In FIG. 2, the auxiliary switching unit SA comprises a single semiconductor switch with antiparallel diode only. However, there may be provided several parallel semiconductor switches instead.

There is further provided a voltage measurement unit 9 which measures the on-state voltage over the switching unit S1, i.e., the on-state voltage over the plurality of semiconductor switches S11 to S16. The on-state voltage is the same for all semiconductor switches S11 to S16 in accordance with the rules that apply for parallel connections.

By measuring the on-state voltage it is possible to analyze the health situation of the semiconductor switches S11 to S16. Such health analysis is carried out before a faulty semiconductor switch is removed as described with respect to FIG. 1. Also, in alternative embodiments, the analysis of the health situation of the semiconductor switch S11 to S16 may lead to the decision to replace the switching unit S1 altogether.

In an alternative embodiment of FIG. 2, two switching units S1, S2 are implemented similar as in FIG. 1, wherein each of the switching units S1, S2 is associated with a voltage measurement unit 9.

By providing the additional voltage measurement unit 9 that monitors the on-state voltage of the parallel semiconductor switches S11 to S16, it is possible to analyze the health situation of the parallel semiconductor switches. This is next discussed with respect to three embodiments which are depicted in FIGS. 3 to 5.

FIG. 3 is a flowchart of a general method for detecting the health of a first switching unit (such as switching unit S1 of FIGS. 1, 2) of a power system, wherein the first switching unit S1 comprises a plurality of first semiconductor switches (such as first semiconductor switches S11-S16) arranged in parallel. There is further provided at least one further switching unit (the auxiliary switching unit SA in FIGS. 1, 2), wherein the first switching unit S1 and the further switching unit SA are arranged in a current path such that a current passes through them when both are switched on. In such structure, according to step 301, **initially** the first parallel semiconductor switches of the first switching unit and the further switching unit are switched off, such that there is no current flow. For switching off the semiconductor switches and the further switching unit, the respective gate voltages are controlled accordingly.

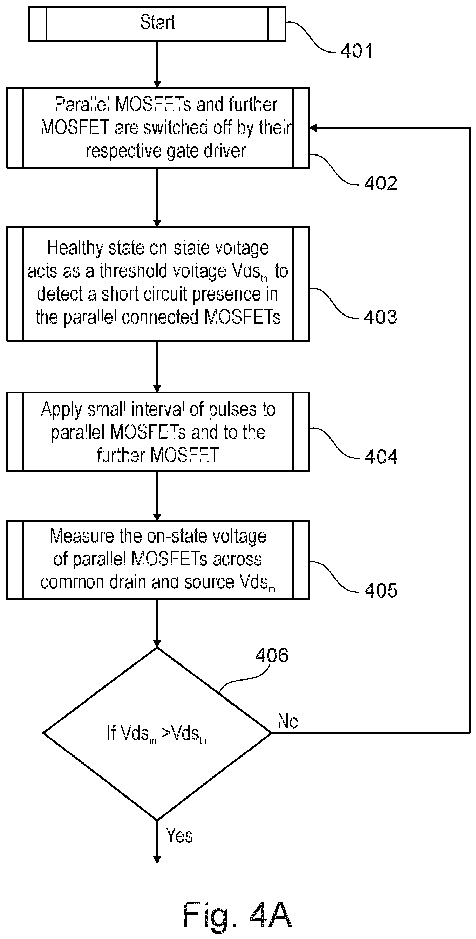

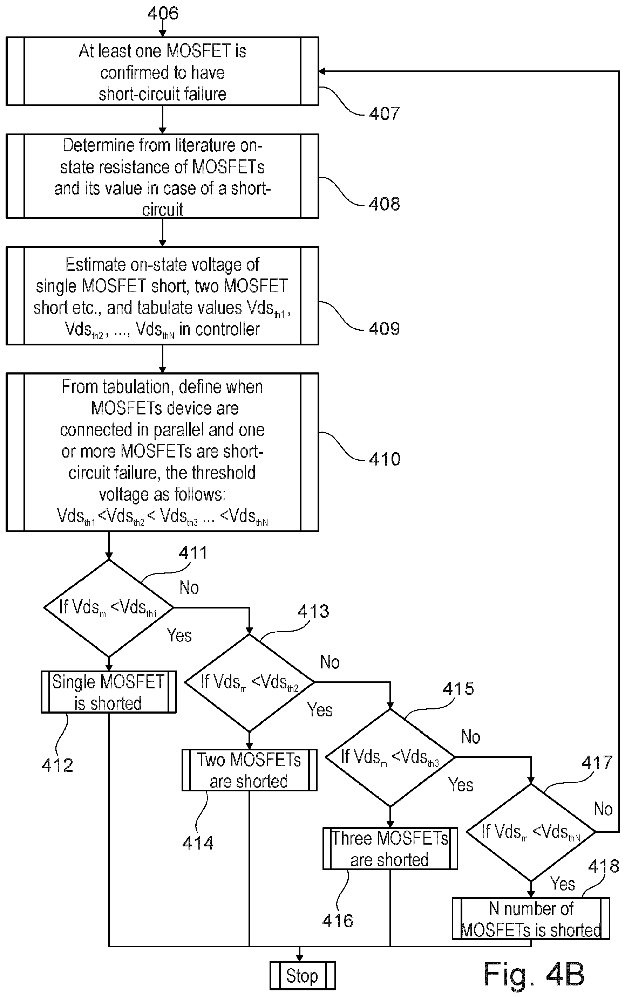

Subsequently, in step 302, the further switching unit is switched on in a pulsed manner. It is then determined in step 303 if there is a current flow between the switched off first parallel semiconductor switches and the further switching unit. Such determination may be implemented in a plurality of manners, wherein one embodiment is explained in more detail with respect to FIG. 4. In a most simple implementation, the first semiconductor switches remain switched off, such that the presence of a current flow indicates that one or several of the first semiconductor switches are short-circuited, as otherwise they would not pass any current, as switched off. Accordingly, a current flow indicates a short circuit fault condition of one or several of the first semiconductor switches and thus of the first switching unit, If there is a current flow, and, accordingly, a short-circuit fault condition, it is then of interest to know how many of the first semiconductor switches are short-circuited. Such information, e.g., may determine the length of the pulses and the current passing through the auxiliary switching unit SA in FIGS. 1, 2, and may further determine if a switching unit needs to be fully replaced.

According to step 305, the number of short-circuited first semiconductor switches in the first switching unit is determined by measuring the on-state voltage Vdsₘ over the plurality of first semiconductor switches and by comparing the measured on-state voltage Vdsₘ with at least one of N predetermined threshold voltages over the plurality of first semiconductor switches, wherein the N predetermined threshold voltages differ dependent on the number of short-circuited first semiconductor switches. In this respect, it applies that M ≥ N ≥ 2, wherein M is the number of first semiconductor switches and N is a natural number. By comparing the on-state voltage with the different predetermined threshold voltages, it can be determined how many of the parallel first semiconductor switches are short-circuited, this being the case as the higher the number of short-circuited semiconductor switches, the higher the on-state voltage. In other words, the on-state voltage increases with the number of a faulty semiconductor switches which allows to compare the on-state voltage with different threshold voltages which are associated with different numbers of short-circuited semiconductor switches.

A more detailed embodiment of the method of FIG. 3 is depicted in FIG. 4, which consists of FIG. 4A and FIG. 4B. Steps 401 to 406 serve to determine if there is a current flow between the switched off first parallel semiconductor switches and the further switching unit, wherein the presence of such a current flow is determined indirectly by considering the voltage measured by a voltage measurement device (such as voltage measurement device 9 of FIG. 2). More particularly, after the start of the procedure in step 401, the first parallel semiconductor switches (which are MOSFETs in the discussed embodiment, wherein the terms "semiconductor switch" and MOSFET are in the following both used interchangeably to designate any semiconductor switch) and the further switching unit (which is considered to be another MOSFET in the discussed embodiment) are switched off by their respective gate drivers, such as gate drivers 111 and 113 of FIG. 2. Step 401 corresponds to step 301 of FIG. 3.

Subsequently, in step 403, a threshold voltage Vdsₜₕ is a defined, wherein the threshold voltage Vdsₜₕ is the on-state voltage present when all of the plurality of first semiconductor switches (the parallel MOSFETs) are in a healthy state. This threshold voltage may also be referred to as healthy state threshold voltage. It is used to detect a short-circuit present in the parallel first semiconductor switches (parallel MOSFETs).

The healthy state threshold voltage Vdsₜₕ may simply be measured by an on-state voltage measurement unit. Alternatively, it may be deducted from the datasheet information about the semiconductor switches.

In step 404, a small interval of pulses is applied both to the parallel first semiconductor switches (parallel MOSFETs) and the further switching unit (MOSFET). It is then measured in step 405 the actual on-state voltage Vdsₘ over the plurality of parallel first semiconductor (parallel MOSFETs), wherein the voltage across common drain and source is measured. Generally, an on-state voltage is measured as the voltage drop between drain and source (also for the threshold voltage Vdsₜₕ and other threshold voltages). In step 406, the measured on-state voltage Vdsₘ of the plurality of first semiconductor switches is compared with the predetermined healthy threshold voltage. If the measured on-state voltage Vdsₘ is larger than the predetermined healthy threshold voltage Vdsₜₕ, there is a current flow between the switched off first semiconductor switches (parallel MOSFETs) and the further switching unit (MOSFET). This is the case as the measured on-state voltage Vdsₘ is increased when one or several of the parallel MOSFETs are short-circuited.

The procedure continues with step 407 of FIG. 4B. If the measured on-state voltage Vdsₘ is larger than the predetermined healthy threshold voltage Vdsₜₕ it is confirmed that at least one of the first semiconductor switches/parallel MOSFETs has a short-circuit failure, step 407. The remaining steps of FIG. 4B serve to determine the number of short-circuited semiconductor switches.

In this respect, specific threshold voltages are first defined/determined. In particular, a first predetermined threshold voltage Vdsₜₕ₁ is defined that refers to an on-state voltage over the plurality of first semiconductor switches present when one of the plurality of first semiconductor switches is in a short-circuited state. Similarly, a second predetermined threshold voltage Vdsₜₕ₂ is a defined that refers to an on-state voltage over the plurality of first semiconductor switches present when two of the plurality of first semiconductor switches are in a short-circuited state. In the same manner, a third, fourth, fifth, etc. predetermined threshold voltage may be defined. An Nth predetermined threshold voltage Vds_{thN} refers to an on-state voltage over the plurality of first semiconductor switches present when N of the plurality of first semiconductor switches are in short-circuited state. It is to be noted that Vdsₜₕ < Vdsₜₕ₁ < Vdsₜₕ₂ < Vdsₜₕ₃ < Vds_{thN}, as the more of the parallel semiconductor switches/MOSFETs are short-circuited, the higher is the on-state voltage measured by the voltage measurement unit.

Determining of the mentioned voltage Vdsₜₕ, Vdsₜₕ₁, ..., Vds_{thN} takes place in steps in the depicted embodiment, wherein in step 408 the on-state resistance of MOSFETs and its value in case of a short-circuit is determined. From the on-state resistance of a single MOSFETs, in step 409 the on-state voltage of the parallel MOSFETs is determined in case a single MOSFETs is short-circuited, in case two MOSFETs are short-circuited, etc., wherein the values Vdsₜₕ, Vdsₜₕ₁, ..., Vds_{thN} are tabulated in a controller (such as controller 5 in FIGS. 1 and 2).

In step 410, the voltages Vdsₜₕ, Vdsₜₕ₁, ..., Vds_{thN} from the tabulation are defined as threshold voltages, wherein Vdsₜₕ < Vdsₜₕ₁ < Vdsₜₕ₂ < Vdsₜₕ₃ < Vds_{thN}.

It then follows a sequence of comparisons. In step 411, it is determined if the measured on-state voltage Vdsₘ of the plurality of first semiconductor switches (that have been measured in step 405 and/or may be measured again) is smaller than the first threshold value Vdsₜₕ₁. If so, it is determined in step 412 that one of the first semiconductor switches is short-circuited, and the method stops in step 419.

If this is not the case (Vdsₘ is not smaller than Vdsₜₕ₁), it is determined in step 413 if the measured on-state voltage Vdsₘ is smaller than the second predetermined threshold voltage Vdsₜₕ₂. If so, it is determined in step 414 that two of the first semiconductor switches are short-circuited, and the method stops in step 419. If not so, such comparison continues in steps 415, 416 and potentially further steps until step 417 in which the measured on-state voltage Vdsₘ is compared with the Nth predetermined threshold voltage Vds_{thN}. If the measured on-state voltage Vdsₘ is smaller than the Nth predetermined threshold voltage Vds_{thN}, it is further determined in step 418 that N of the first semiconductor switches are short-circuited. Otherwise, a determination of the number of MOSFETs was not able to be made and the method returns to step 407.

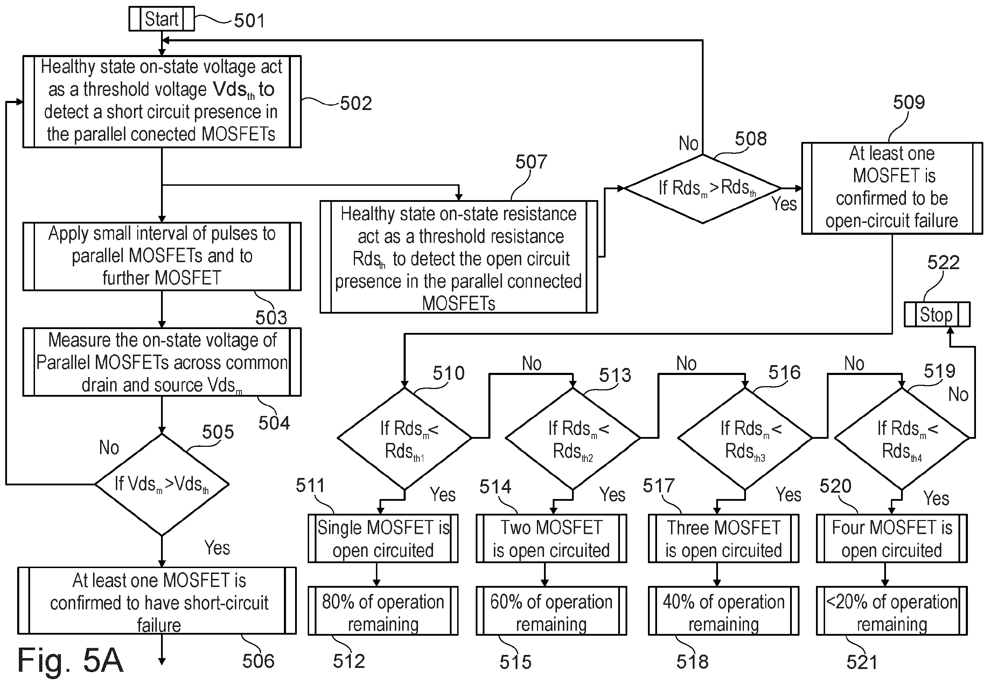

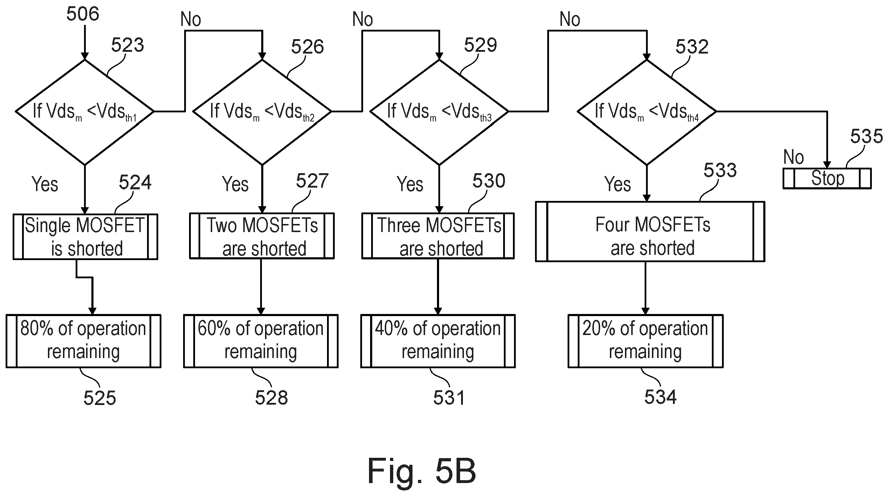

FIG. 5, which consists of FIG. 5A and FIG. 5B, is a variant of the method discussed with respect to FIG. 4, wherein additionally it is determined the number first semiconductor switches which have an open circuit failure. Accordingly, both the number of semiconductor switches/MOSFETs with a short-circuit failure and the number of semiconductor switches/MOSFETs with an open circuit failure are determined.

The procedure starts in step 501. Steps 502 to 506 correspond to steps 403 to 407 of FIG. 4, wherein a step similar to step 402 is also implemented in FIG. 5 but not explicitly shown. Accordingly, in steps 502 to 506 it is determined by means of the measured on-state voltage Vdsₘ over the parallel MOSFETs if at least one of the MOSFETs has a short-circuit failure. In such case, according to FIG. 5B, a comparison with a plurality of predetermined threshold voltages Vdsₜₕ, Vdsₜₕ₁, ..., Vdsₜₕ₄ is carried out, wherein steps 523 to 535 generally correspond to steps 411 to 419 of FIG. 4. In this respect, it is pointed out that steps 408 to 410 of FIG. 4 are not depicted in FIG. 5 but it may still be implemented as a way to determine the predetermined threshold voltages Vdsₜₕ, Vdsₜₕ₁, ..., Vds_{thN}. Further, compared to FIG. 4, FIG. 5 further comprises steps 525, 528, 531 and 534 which indicate that the operational capability of the system is reduced in accordance with the number of short-circuited MOSFETs.

The main differing features of FIG. 5 compared to FIG. 4 regards the determination of how many of the parallel MOSFETs have an open circuit failure. This is explained in steps 507 to 522 in the right hand side of Fig. 5A.

These steps shift from considering the on-state voltage to considering the on-state resistance. To this end, a measured on-state resistance Rdsₘ of a first switching unit can be determined from the measured on-state voltage Vdsₘ using the formula ${Rds}_{m} \left(t\right) = {Vds}_{m} \left(t\right) / {i}_{d} \left(t\right)$ wherein Rdsₘ (t) the on-state resistance of the first switching unit S1; Vdsₘ (t) is the on-state voltage over the first switching unit S1; and i_{d} (t) is the current through the first switching unit S1, it is assumed that the current i_{d} is given.

In a similar manner, a predefined threshold voltage can be converted into a predefined threshold resistance.

In step 507, a healthy state on-state resistance Rdsₜₕ is determined from the healthy state on-state voltage provided in step 502, wherein the healthy state on-state resistance Rdsₜₕ regards the situation in which all of the plurality of first semiconductor switches are in a healthy state. It is then compared in a step 508 if the measured on-state resistance Rdsₘ of the first switching unit is larger than the healthy state on-state resistance Rdsₜₕ. If this is the case, this is an indication that at least one of the first semiconductor switches has an open circuit failure, step 509, for the reason that the measured on-state resistance increases with the number of open-circuited semiconductor switches. In particular, if there is an opened circuit fault in one of the semiconductor switches, there is an increase in the on-state resistance value such that in the on-state resistance value Rdsₘ is larger than the healthy state on-state resistance value Rdsₜₕ.

To determine the number of open-circuited first semiconductor switches in the first switching unit, the on-state resistance Rdsₘ of the first switching unit is compared with least one of N predetermined resistance threshold values. Accordingly, a sequence of comparisons follows next. In step 510, it is determined if the measured on-state resistance Rdsₘ of the plurality of first semiconductor switches is smaller than the first predetermined resistance threshold value Rdsₜₕ₁, wherein the first predetermined resistance threshold value Rdsₜₕ₁ refers to an on-state resistance present when one of the plurality of first semiconductor switches is in an open-circuit state. If so, it is determined in step 511 that one of the first semiconductor switches is open-circuited. This means that the system operational capacity is reduced to 80 percent of its original value, as shown in step 512.

If this is not the case (Rdsₘ is not smaller than Rdsₜₕ₁), it is determined in step 513 if the measured on-state resistance Rdsₘ is smaller than the second predetermined resistance threshold value Rdsₜₕ₂ which refers to an on-state resistance present when two of the plurality of first semiconductor switches are in an open-circuit state. If so, it is determined in step 514 that two of the first semiconductor switches are open-circuited. This means that the system operational capacity is reduced to 60 percent of its original value, as shown in step 515. If not so, such comparison continues in steps 516 and 519 in which the measured on-state voltage Vdsm is compared with the third respectively the fourth predetermined resistance threshold value Rdsₜₕ₃, Rdsₜₕ₄ (wherein the number N of predetermined resistance threshold values is equal to 4 in the depicted embodiment). If the measured on-state resistance Rdsₘ is smaller than the 3rd/4th predetermined resistance threshold value Rdsₜₕ₃, Rdsₜₕ₄, it is further determined in steps 517, 520 that three or four of the parallel semiconductor switches are open-circuited, this further indicating that the system operational capacity is reduced to 40 percent respectively 20 percent of the original value, steps 518, 521. The method stops at step 522.

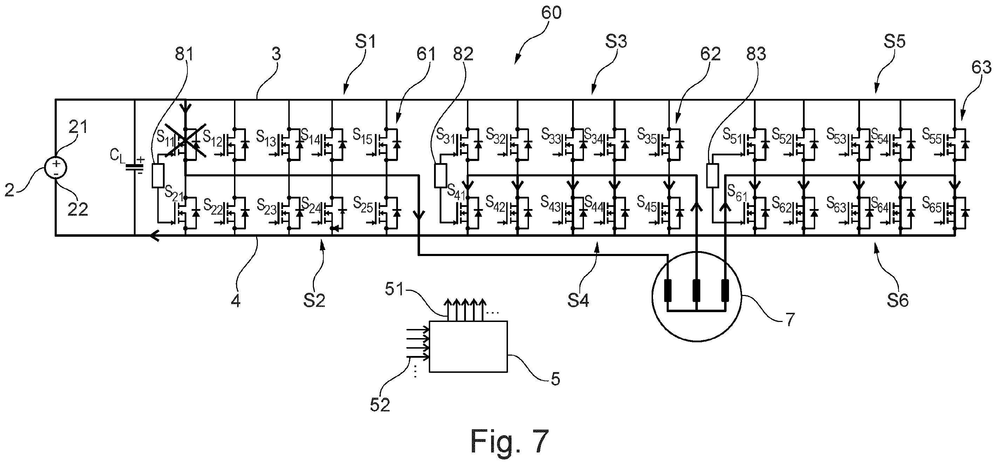

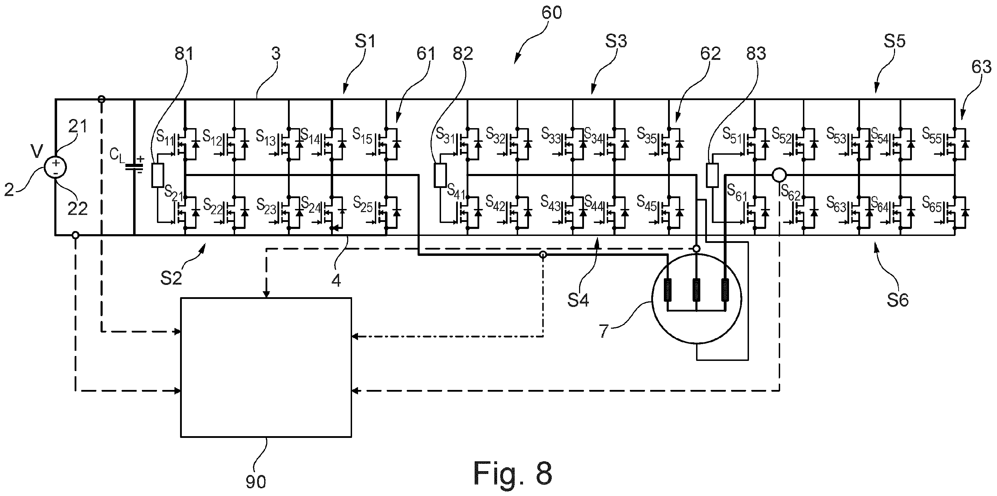

The principles of the present invention are not limited to a particular kind of circuit. Detection of the health of a switching unit which comprises a plurality of parallel semiconductor switches may be implemented in any circuit in which a switching unit and a further switching unit are arranged such that a current may pass through them when both are switched on. One example circuit in which the method may be implemented has been described with respect to FIGS. 1 and 2 regarding an SSPC. Further example circuits are a DC/DC converter, as will be discussed with respect to FIG. 6, and a power converter, as will be discussed with respect to FIGS. 7 and 8.

FIG. 6 shows an embodiment of a DC power which comprises a DC power source 2, an input positive voltage rail 31, an output positive voltage rail 32, and a common negative voltage rail 4, a filtering capacitor C_{L}, a DC/DC converter 6, a load R and a capacitive load C_{H}.

The DC/DC converter comprises four switching units S1-S4 arranged in parallel first and second legs 61, 62, wherein the first leg 61 comprises a top switching unit S1 connected to the input positive voltage rail 31 and a bottom switching unit S2 connected to the negative voltage rail 4, wherein the second leg 62 comprises a top switching unit S3 connected to the output positive voltage rail 32 and a bottom switching unit S4 connected to the negative voltage rail 4. Each of the switching units S1-S4 is comprised of a plurality of semiconductor switches S11-S15, S21-S25, S31-S35, S41-S45 arranged in parallel. More particularly, switching unit S1 comprises semiconductor switches S11-S15, switching unit S2 comprises semiconductor switches S21-S25, etc.

The power system further comprises two gate drivers 81, 82 for the semiconductor switches S11-S15, S21-S25, S31-S35, S41-S45. In the depicted embodiment, but not necessarily, a separate common gate driver is provided for the semiconductor switches of each leg 61, 62. Accordingly, gate driver 81 provides control signals to the control terminals of semiconductor switches S11-S15 and S21-S25, and gate driver 82 provides control signals to the control terminals of semiconductor switches S31-S35 and S41-S45. In other embodiments, there may be provided a separate gate driver for each switching unit S1-S4 or there may even be provided a separate gate driver for each semiconductor switch.

By implementing a plurality of parallel semiconductor switches for each switching unit S1-S4, it is easier to meet the power requirements, as the current capacity can be increased with each additional parallel semiconductor switch. However, switching devices may fail due to multiple reasons, such as overvoltage, EMI, high dv/dt, unequal current sharing, manufacturing defects, etc. With a large number of parallel semiconductor switches, there is an increased risk of failure of a semiconductor switch. However, the failure of a single semiconductor switch may lead to a complete shutdown of the DC/DC converter.

To address this problem, the DC power system of FIG. 1 implements a servicing method which allows to service the DC power system by removing a faulty semiconductor switch without damaging the other semiconductor switches.

To implement such function, and also to implement functions and methods in accordance with FIGS. 3-5, the DC power system comprises a controller 5 which is depicted schematically. The controller comprises input lines 52 and output lines 51. In particular, the controller communicates 5 through input lines 52 and output lines 51 with the gate drivers 81, 82 and with one or several voltage measurement units (not shown) similar to voltage measurement unit 9 of FIG. 2. For example, each of switching units S1 to S4 may be associated with a voltage measurement unit similar to voltage measurement unit 9 of FIG. 2.

Accordingly, the controller 5 is configured to receive information or determine from the received information that one or several of the semiconductor switches of the switching units S1-S4 has a fault condition. The information that one of the semiconductor switches has experienced a fault can be provided in a manner as is discussed with respect to FIGS. 3 to 5.

In FIG. 6, as an example the situation is considered that switch S11 of switching unit S1 of leg 61 is short-circuited. In case such fault condition is detected, the controller 5 is configured to switch off all semiconductor switches of the switching unit that comprises the faulty semiconductor switch S11, which is switching unit S1 in the present case. Accordingly, semiconductor switches S11-S15 are switched off (by means of gate driver 81 receiving respective control signals from controller 5 through output lines 51).

At the same time, the controller 5 provides control signals to gate drive 82 to the effect that the switching unit S4 is completely switched on, i.e., semiconductor switches S41-S45 are switched on. This leads to the situation that a current from the DC power source 2 is guided through the faulty semiconductor switch S11 of switching unit S1 only and is further guided through all semiconductor switches S41-S45 of switching unit S4. It is to be noted that switching unit S4 is a further switching unit within the meaning of the present invention. As the current is concentrated on the faulty semiconductor switch S11 in switching unit S1, the faulty semiconductor switch S11 is burned by the current and, thereby, removed from the switching unit S1. In particular, a previous short-circuit of the semiconductor switch S11 is transformed by the burning into an open state of the semiconductor switch S11.

For removing the faulty semiconductor switch S11, the controller 5 may control the semiconductor switches S41-S45 of switching unit S4 such that a pre-determined continuous stream of pulses is applied when a fault condition is present. This allows the semiconductor switch S11 to be blown off safely without damaging the semiconductor switches S41-S45 and S61-S65.

FIG. 7 shows an embodiment of a DC power system that comprises a DC power source 2, a positive voltage rail 3, a negative voltage rail 4, a filtering capacitor C_{L} and a power converter 6 (which is an inverter) arranged between the positive voltage rail 3 and the negative voltage rail 4, the power converter 6 providing a three phase alternating current to a load 7 such as an electric motor.

The power converter comprises six switching units S1-S6 arranged in three parallel legs 61-63, each leg comprising a top switching unit S1, S3, S5 connected to the positive voltage rail 3 and a bottom switching unit S2, S4, S6 connected to the negative voltage rail 4. The switching units S1-S6 each comprise a plurality of semiconductor switches S11-S15, S21-S25, S31-S35, S41-S45, S51-S55, S61-S65 arranged in parallel. More particularly, switching unit S1 comprises semiconductor switches S11-S15, switching unit S2 comprises semiconductor switches S21-S25, etc.

The power system further comprises gate drivers 81-83 for the semiconductor switches S11-S15, S21-S25, S31-S35, S41-S45, S51-S55, S61-S65. In the depicted embodiment, but not necessarily, a separate common gate driver is provided for the semiconductor switches of each leg 61, 62, 63. Accordingly, e.g., gate driver 81 provides control signals to the control terminals of semiconductor switches S11-S15 and S21-S25. In other embodiments, there may be provided a separate gate driver for each switching unit S1-S6 or there may even be provided a separate gate driver for each semiconductor switch.

By implementing a plurality of parallel semiconductor switches for each switching unit S1-S6, it is easier to meet the power requirements, as the current capacity can be increased with each additional parallel semiconductor switch. However, switching devices may fail due to multiple reasons, such as overvoltage, EMI, high dv/dt, unequal current sharing, manufacturing defects, etc. With a large number of parallel semiconductor switches, there is an increased risk of failure of a semiconductor switch. However, the failure of a single semiconductor switch may lead to a complete shutdown of the power converter.

To address this problem, the DC power system of FIG. 7 implements a servicing method which allows to service the DC power system by removing a faulty semiconductor switch without damaging the other semiconductor switches.

To implement such function, and also implement functions in accordance with FIGS. 3-5, the DC power system comprises a controller 5 which is depicted schematically. The controller comprises input lines 52 and output lines 51. In particular, the controller communicates 5 through input lines 52 and output lines 51 with the gate drivers 81-83, and with one or several voltage measurement units (not shown) similar to voltage measurement unit 9 of FIG. 2. For example, each of switching units S1 to S6 may be associated with a voltage measurement unit similar to voltage measurement unit 9 of FIG. 2.

In FIG. 7, as an example the situation is considered that switch S11 of switching unit S1 of leg 61 is short-circuited. The information that one of the semiconductor switches has experienced a fault can be provided in a manner as is discussed with respect to FIGS. 3 to 5. In case a fault condition of a semiconductor switch is detected (in the depicted example semiconductor switch S11), the controller 5 is configured to switch off all semiconductor switches of the switching unit that comprises the faulty semiconductor switch S11, which is switching unit S11 in the present case. Accordingly, semiconductor switches S11-S15 are switched off (by means of gate driver 81 receiving respective control signals from controller 5 through output lines 51).

At the same time, the controller 5 provides control signals to gate drivers 82, 83 to the effect that the switching units S4 and S6 are completely switched on, i.e., semiconductor switches S41-S45 and S61-S65 are switched on. This leads to the situation that a current from the DC power source 2 is guided through the faulty semiconductor switch S11 of switching unit S1 only and is further guided through all semiconductor switches S41-S45 and S61-S65 of switching units S4 and S6. It is to be noted that switching units S4, S6 are further switching units within the meaning of the present invention.

As the current is concentrated on the faulty semiconductor switch S11 in switching unit S1, the faulty semiconductor switch S11 is burned by the current and, thereby, removed from the switching unit S1. In particular, a previous short-circuit of the semiconductor switch S11 is transformed by the burning into an open state of the semiconductor switch S11.

For removing the faulty semiconductor switch S11, the controller 5 may control the semiconductor switches S41-S45 and S61-S65 of switching units S4 and S6 such that a pre-determined continuous stream of pulses is applied when a fault condition is present. This allows the semiconductor switch S11 to be blown off safely without damaging the semiconductor switches S41-S45 and S61-S65.

FIG. 8 shows the power system of FIG. 7, wherein additionally an evaluation unit 90 is depicted which measures/monitors the phase current, the DC link voltage and phase-to-phase voltage of the power device. Based on these measurements, the on-state voltage over the plurality of semiconductor switches of the switching unit which is analyzed for its health (which may be any of switching units S1 to S6) and also the on-state resistance of the respective switching unit can be determined indirectly. In addition or alternatively, each of the switching units S1 to S6 may be associated with a voltage measurement unit similar to voltage measurement unit 9 of FIG. 2.

The invention is defined by the appended claims.

## Claims

1. A method for detecting the health of a first switching unit (S1) of a power system, wherein the first switching unit (S1) comprises a plurality of first semiconductor switches (S11-S16) arranged in parallel, wherein the power system further comprises at least one further switching unit (SA, S4-S6), and wherein the first switching unit (S1) and the further switching unit (SA, S4-S6) are arranged in a current path such that a current passes through them when both are switched on, and wherein the method comprises the steps of:
switching off (301) the first parallel semiconductor switches (S11-S16) of the first switching unit (S1) and switching off the further switching unit (SA, S4-S6);
**characterized by**
switching on (302) the further switching unit (SA, S4-S6) in a pulsed manner;
determining (303) if there is a current flow between the switched off first parallel semiconductor switches (S11-S16) and the further switching unit (SA, S4-S6), wherein a current flow indicates a short circuit fault condition of the first switching unit (S1); and
if there is a current flow, determining (304) the number of short-circuited first semiconductor switches (S11-S16) in the first switching unit (S1) by measuring (305) the on-state voltage (Vdsₘ) over the plurality of first semiconductor switches (S11-S16) and comparing the measured on-state voltage (Vdsₘ) with at least one of N predetermined threshold voltages over the plurality of first semiconductor switches (S11-S16) which differ dependent on the number of short-circuited first semiconductor switches (S11-S16), wherein M ≥ N ≥ 2, M is the number of the first semiconductor switches (S11-S16) and N is a natural number.

2. The method of claim 1, wherein:
a first predetermined threshold voltage (Vdsₜₕ₁) refers to an on-state voltage over the plurality of first semiconductor switches (S11-S16) present when one of the plurality of first semiconductor switches (S11-S16) is in a short-circuited state; and
an Nth predetermined threshold voltage (Vds_{thN}) refers to an on-state voltage over the plurality of first semiconductor switches (S11-S16) present when N of the plurality of first semiconductor switches (S11-S16) are in short-circuited state;
wherein determining the number of short-circuited first semiconductor switches (S11-S16) in the first switching unit further comprises:
determining (411) if the measured on-state voltage (Vdsₘ) is smaller than the first predetermined threshold voltage (Vdsₜₕ₁) and, if so, further determine (412) that one of the first semiconductor switches (S11-S16) is short-circuited;
if not, determining (413) if the measured on-state voltage (Vdsₘ) is smaller than the second predetermined threshold voltage (Vdsₜₕ₂) and, if so, further determine (414) that two of the first semiconductor switches (S11-S16) are short-circuited; and
as long as the number of short-circuited first semiconductor switches (S11-S16) has not been determined, repeating the comparison (415, 417) up to the Nth predetermined threshold voltage (Vds_{thN}), wherein with the Nth predetermined threshold voltage (Vds_{thN}) it is determined (417) if the measured on-state voltage (Vdsₘ) is smaller than the Nth predetermined threshold voltage (Vds_{thN}) and, if so, it is further determined (418) that N of the first semiconductor switches (S11-S16) are short-circuited.

3. The method of claim 1 or 2, wherein the determining if there is a current flow between the switched off first parallel semiconductor switches (S11-S16) and the further switching unit (SA, S4-S6) comprises:
switching on (404) the first parallel semiconductor switches (S11-S16) of the first switching unit (S1) and switching on (404) the further switching unit (SA, S4-S6) in a pulsed manner;
measuring (405) the on-state voltage (Vdsₘ) over the plurality of first semiconductor switches (S11-S16) during the applying of pulses;
comparing (406) the measured on-state voltage (Vdsₘ) of the plurality of first semiconductor switches (S11-S16) with a predetermined healthy state threshold voltage (Vdsₜₕ), wherein the predetermined healthy state threshold voltage (Vdsₜₕ) refers to an on-state voltage present when all of the plurality of first semiconductor switches (S11-S16) are in a healthy state; and
determining (406) if the measured on-state voltage (Vdsₘ) is larger than the predetermined healthy state threshold voltage (Vdsₜₕ).

4. The method of any preceding claim, wherein a current is guided through only the short-circuited first semiconductor switches (S11-S16) of the first switching unit (S1) and through the further switching unit (SA, S4-S6) to burn the short-circuited first semiconductor switches (S11-S16) or series fuses respectively arranged in series with the short-circuited semiconductor switches (S11-S16), wherein the current is dependent on the number of short-circuited first semiconductor switches (S11-S16).

5. The method of any preceding claim, wherein from the measured on-state voltage (Vdsₘ) the on-state resistance (Rdsₘ) of the first switching unit (S1) is determined, wherein, to determine the number of open-circuited first semiconductor switches (S11-S16) in the first switching unit (S1), the on-state resistance (Rdsₘ) of the first switching unit (S1) is compared with least one of N predetermined resistance threshold values which differ dependent on the number of open-circuited first semiconductor switches (S11-S16), wherein M ≥ N ≥ 2, M is the number of first semiconductor switches (S11-S16) and N is a natural number.

6. The method of claim 5, wherein:
a first predetermined resistance threshold value (Rdsₜₕ₁) refers to an on-state resistance present when one of the plurality of first semiconductor switches (S11-S16) is in an open-circuit state; and
an Nth predetermined resistance threshold value (Rds_{thN}) refers to an on-state resistance present when N of the plurality of first semiconductor switches (S11-S16) are in an open-circuit state;
wherein determining the number of open-circuited first semiconductor switches (S11-S16) in the first switching unit (S1) further comprises:
determining (510) if the on-state resistance (Rdsₘ) is smaller than the first predetermined resistance threshold value (Rdsₜₕ₁) and, if so, further determining (511) that one of the first semiconductor switches (S11-S16) is open-circuited;
if not, determining (513) if the measured on-state resistance (Rdsₘ) is smaller than the second predetermined resistance threshold value (Rdsₜₕ₂) and, if so, further determining (514) that two of the first semiconductor switches (S11-S16) are open-circuited; and
as long as the number of open-circuited first semiconductor switches (S11-S16) has not been determined, repeating the comparison (516, 519) up to the Nth predetermined resistance threshold value (Rds_{thN}), wherein with the Nth predetermined resistance threshold value (Rds_{thN}) it is determined if the on-state resistance (Rdsₘ) is smaller than the Nth predetermined resistance threshold value (Rds_{thN}) and, if so, it is further determined that N of the first semiconductor switches (S11-S16) are open-circuited.

7. The method of claim 5, wherein the on-state resistance (Rdsₘ) of the first switching unit (S1) is determined from the measured on-state voltage (Vdsₘ) using the formula ${Rds}_{m} \left(t\right) = {Vds}_{m} \left(t\right) / {i}_{d} \left(t\right)$ wherein
Rdsₘ (t) the on-state resistance of the first switching unit (S1);
Vdsₘ (t) is the on-state voltage over the first switching unit (S1); and
i_{d} (t) is the current through the first switching unit (S1).

8. The method of any preceding claim, wherein a pre-determined continuous stream of pulses is applied to a control terminal of the further switching unit (SA, S4-S6) when switching on the further switching unit (SA, S4-S6) in a pulsed manner.

9. The method of any preceding claim, wherein the first parallel semiconductor switches (S11-S16) of the first switching unit (S1) are controlled by a single gate driver (111).

10. A power system comprising:
a power bus (3, 4) comprising a first voltage rail (3) and a second voltage rail (4);
a first switching unit (S1) arranged in the first voltage rail (3) or the second voltage rail (4), wherein the first switching unit (S1) comprises a plurality of first semiconductor switches (S11-S16) arranged in parallel;
at least one further switching unit (SA, S4-S6), wherein the first switching unit (S1) and the further switching unit (SA, S4-S6) are configured and arranged in the power system such that a current path passes through them when both are switched on;
a voltage measurement unit (9) configured to measure the on-state voltage (Vdsₘ) over the plurality of first semiconductor switches (S11-S16);
**characterized by**
a controller (5) configured to:
switch off (301) the first parallel semiconductor switches (S11-S16) of the first switching unit (S1) and switching off the further switching unit (SA, S4-S6);
switch on (302) the further switching unit (SA, S4-S6) in a pulsed manner;
determine (303) if there is a current flow between the switched off first parallel semiconductor switches (S11-S16) and the further switching unit (SA, S4-S6), wherein a current flow indicates a short circuit fault condition of the first switching unit (S1); and
if there is a current flow, determine (304) the number of short-circuited first semiconductor switches (S11-S16) in the first switching unit (S1) by measuring (305) the on-state voltage (Vdsₘ) over the plurality of first semiconductor switches (S11-S16) by means of the voltage measurement unit (9) and comparing the measured on-state voltage (Vdsₘ) with at least one of N predetermined threshold voltages over the plurality of first semiconductor switches (S11-S16) which differ dependent on the number of short-circuited first semiconductor switches (S11-S16), wherein M ≥ N ≥ 2, M is the number of the first semiconductor switches (S11-S16) and N is a natural number.

11. The power system of claim 10, wherein:
- a first predetermined threshold voltage (Vdsₜₕ₁) refers to an on-state voltage over the plurality of first semiconductor switches (S11-S16) present when one of the plurality of first semiconductor switches (S11-S16) is in a short-circuited state; and
- an Nth predetermined threshold voltage (Vds_{thN}) refers to an on-state voltage over the plurality of first semiconductor switches (S11-S16) present when N of the plurality of first semiconductor switches (S11-S16) are in short-circuited state;
wherein the controller (5) is configured to determine the number of short-circuited first semiconductor switches (S11-S16) in the first switching unit (S1) by:
determining (411) if the on-state voltage (Vdsₘ) measured by the voltage measurement unit (9) is smaller than the first predetermined threshold voltage (Vdsₜₕ₁) and, if so, further determining (412) that one of the first semiconductor switches (S11-S16) is short-circuited;
if not, determining (413) if the measured on-state voltage (Vdsₘ) is smaller than the second predetermined threshold voltage (Vdsₜₕ₂) and, if so, further determining (414) that two of the first semiconductor switches (S11-S16) are short-circuited; and
as long as the number of short-circuited first semiconductor switches (S11-S16) has not been determined, repeating the comparison (415, 417) up to the Nth predetermined threshold voltage (Vds_{thN}), wherein with the Nth predetermined threshold voltage (Vds_{thN}) it is determined (417) if the measured on-state voltage (Vdsₘ) is smaller than the Nth predetermined threshold voltage (Vds_{thN}) and, if so, it is further determined (418) that N of the first semiconductor switches (S11-S16) are short-circuited.

12. The power system of claim 10 or 11, wherein the controller (5) is configured to determine if there is a current flow between the switched off first parallel semiconductor switches (S11-S16) and the further switching unit (SA, S4-S6) by:
switching on (404) the first parallel semiconductor switches (S11-S16) of the first switching unit (S1) and switching on (404) the further switching unit (SA, S4-S6) in a pulsed manner;
measuring (405) the on-state voltage (Vdsₘ) over the plurality of first semiconductor switches (S11-S16) by means of the voltage measurement unit (9) during the applying of pulses;
comparing (406) the measured on-state voltage (Vdsₘ) of the plurality of first semiconductor switches (S11-S16) with a predetermined healthy state threshold voltage (Vdsₜₕ), wherein the predetermined healthy state threshold voltage (Vdsₜₕ) refers to an on-state voltage present when all of the plurality of first semiconductor switches (S11-S16) are in a healthy state; and
determining (406) if the measured on-state voltage (Vdsₘ) is larger than the predetermined healthy state threshold voltage (Vdsₜₕ).

13. The power system of any one of claims 10 to 12, wherein the controller (5) is further configured to control the system such that a current is guided through only the short-circuited first semiconductor switches (S11-S16) of the first switching unit (S1) and through the further switching unit to burn the short-circuited first semiconductor switches (S11-S16) or series fuses respectively arranged in series with the short-circuited semiconductor switches (S11-S16), wherein the current is dependent on the number of short-circuited first semiconductor switches (S11-S16).

14. The power system of any one of claims 10 to 13, wherein the controller (5) is further configured to determine from the measured on-state voltage (Vdsₘ) the on-state resistance (Rdsₘ) of the first switching unit (S1), wherein, to determine the number of open-circuited first semiconductor switches (S11-S16) in the first switching unit (S1), the controller (5) is configured to compare the on-state resistance (Rdsₘ) of the first switching unit (S1) with least one of N predetermined resistance threshold values which differ dependent on the number of open-circuited first semiconductor switches (S11-S16), wherein M ≥ N ≥ 2, M is the number of first semiconductor switches (S11-S16) and N is a natural number.

15. The power system of claim 14, wherein:
a first predetermined resistance threshold value (Rdsₜₕ₁) refers to an on-state resistance present when one of the plurality of first semiconductor switches (S11-S16) is in an open-circuited state; and
an Nth predetermined resistance threshold value (Rds_{thN}) refers to an on-state resistance present when N of the plurality of first semiconductor switches (S11-S16) are in open-circuited state;
wherein the controller (5) is configured to determine the number of open-circuited first semiconductor switches (S11-S16) in the first switching unit (S1) by:
determining (510) if the on-state resistance (Rdsₘ) is smaller than the first predetermined resistance threshold value (Rdsₜₕ₁) and, if so, further determining (511) that one of the first semiconductor switches (S11-S16) is open-circuited,
if not, determining (513) if the measured on-state resistance (Rdsₘ) is smaller than the second predetermined resistance threshold value (Rdsₜₕ₂) and, if so, further determining (514) that two of the first semiconductor switches (S11-S16) are open-circuited; and
as long as the number of open-circuited first semiconductor switches (S11-S16) has not been determined, repeating the comparison (516, 519) up to the Nth predetermined resistance threshold value (Rds_{thN}), wherein with the Nth predetermined resistance threshold value (Rds_{thN}) it is determined if the on-state resistance (Rdsₘ) is smaller than the Nth predetermined resistance threshold value (Rds_{thN}) and, if so, it is further determined that N of the first semiconductor switches (S11-S16) are open-circuited.

## Patentansprüche

1. Verfahren zur Erkennung des Zustands einer ersten Schalteinheit (S1) eines Stromversorgungssystems, wobei die erste Schalteinheit (S1) eine Vielzahl von ersten Halbleiterschaltern (S11-S16) umfasst, die parallel angeordnet sind, wobei das Stromversorgungssystem ferner mindestens eine weitere Schalteinheit (SA, S4-S6) umfasst und wobei die erste Schalteinheit (S1) und die weitere Schalteinheit (SA, S4-S6) in einem Strompfad so angeordnet sind, dass ein Strom durch sie fließt, wenn beide eingeschaltet sind, und wobei das Verfahren die folgenden Schritte umfasst:
Ausschalten (301) der ersten parallelen Halbleiterschalter (S11-S16) der ersten Schalteinheit (S1) und Ausschalten der weiteren Schalteinheit (SA, S4-S6);
**gekennzeichnet durch**
Einschalten (302) der weiteren Schalteinheit (SA, S4-S6) in einer gepulsten Weise;
Bestimmen (303), ob ein Stromfluss zwischen den ausgeschalteten ersten parallelen Halbleiterschaltern (S11-S16) und der weiteren Schalteinheit (SA, S4-S6) vorliegt, wobei ein Stromfluss einen Kurzschlussfehlerzustand der ersten Schalteinheit (S1) angibt; und
wenn ein Stromfluss vorliegt, Bestimmen (304) der Anzahl von kurzgeschlossenen ersten Halbleiterschaltern (S11-S16) in der ersten Schalteinheit (S1) durch Messen (305) der Durchlassspannung (Vdsₘ) über der Vielzahl von ersten Halbleiterschaltern (S11-S16) und Vergleichen der gemessenen Durchlassspannung (Vdsₘ) mit mindestens einem von N vorbestimmten Schwellenspannungen über der Vielzahl von ersten Halbleiterschaltern (S11-S16), die sich abhängig von der Anzahl von kurzgeschlossenen ersten Halbleiterschaltern (S11-S16) unterscheiden, wobei M > N > 2, M die Anzahl der ersten Halbleiterschalter (S11-S16) ist und N eine natürliche Zahl ist.

2. Verfahren nach Anspruch 1, wobei:
sich eine erste vorbestimmte Schwellenspannung (Vdsₜₕ₁) auf eine Durchlassspannung über der Vielzahl von ersten Halbleiterschaltern (S11-S16) bezieht, die vorhanden ist, wenn sich einer der Vielzahl von ersten Halbleiterschaltern (S11-S16) in einem kurzgeschlossenen Zustand befindet; und
sich eine N-te vorbestimmte Schwellenspannung (Vds_{thN}) auf eine Durchlassspannung über der Vielzahl von ersten Halbleiterschaltern (S11-S16) bezieht, die vorhanden ist, wenn sich N der Vielzahl von ersten Halbleiterschaltern (S11-S16) in einem kurzgeschlossenen Zustand befinden;
wobei das Bestimmen der Anzahl von kurzgeschlossenen ersten Halbleiterschaltern (S11-S16) in der ersten Schalteinheit ferner Folgendes umfasst:
Bestimmen (411), ob die gemessene Durchlassspannung (Vdsₘ) kleiner als die erste vorbestimmte Schwellenspannung (Vdsₜₕ₁) ist, und wenn ja, ferner Bestimmen (412), dass einer der ersten Halbleiterschalter (S11-S16) kurzgeschlossen ist;
wenn nicht, Bestimmen (413), ob die gemessene Durchlassspannung (Vdsₘ) kleiner als die zweite vorbestimmte Schwellenspannung (Vdsₜₕ₂) ist, und wenn ja, ferner Bestimmen (414), dass zwei der ersten Halbleiterschalter (S11-S16) kurzgeschlossen sind; und
solange die Anzahl von kurzgeschlossenen ersten Halbleiterschaltern (S11-S16) nicht bestimmt worden ist, Wiederholen des Vergleichs (415, 417) bis zur N-ten vorbestimmten Schwellenspannung (Vds_{thN}), wobei mit der N-ten vorbestimmten Schwellenspannung (Vds_{thN}) bestimmt wird (417), ob die gemessene Durchlassspannung (Vdsₘ) kleiner als die N-te vorbestimmte Schwellenspannung (Vds_{thN}) ist, und wenn ja, ferner bestimmt wird (418), dass N der ersten Halbleiterschalter (S11-S16) kurzgeschlossen sind.

3. Verfahren nach Anspruch 1 oder 2, wobei das Bestimmen, ob ein Stromfluss zwischen den ausgeschalteten ersten parallelen Halbleiterschaltern (S11-S16) und der weiteren Schalteinheit (SA, S4-S6) vorliegt, Folgendes umfasst:
Einschalten (404) der ersten parallelen Halbleiterschalter (S11-S16) der ersten Schalteinheit (S1) und Einschalten (404) der weiteren Schalteinheit (SA, S4-S6) in einer gepulsten Weise;
Messen (405) der Durchlassspannung (Vdsₘ) über der Vielzahl von ersten Halbleiterschaltern (S11-S16) während des Anlegens von Impulsen;
Vergleichen (406) der gemessenen Durchlassspannung (Vdsₘ) der Vielzahl von ersten Halbleiterschaltern (S11-S16) mit einer vorbestimmten Schwellenspannung in fehlerfreiem Zustand (Vdsₜₕ), wobei sich die vorbestimmte Schwellenspannung in fehlerfreiem Zustand (Vdsₜₕ) auf eine Durchlassspannung bezieht, die vorhanden ist, wenn sich alle der Vielzahl von ersten Halbleiterschaltern (S11-S16) in einem fehlerfreien Zustand befinden; und
Bestimmen (406), ob die gemessene Durchlassspannung (Vdsₘ) größer als die vorbestimmte Schwellenspannung in fehlerfreiem Zustand (Vdsₜₕ) ist.

4. Verfahren nach einem vorhergehenden Anspruch, wobei ein Strom nur durch die kurzgeschlossenen ersten Halbleiterschalter (S11-S16) der ersten Schalteinheit (S1) und durch die weitere Schalteinheit (SA, S4-S6) geleitet wird, um die kurzgeschlossenen ersten Halbleiterschalter (S11-S16) oder Reihensicherungen zu verbrennen, die jeweils in Reihe mit den kurzgeschlossenen Halbleiterschaltern (S11-S16) angeordnet sind, wobei der Strom von der Anzahl der kurzgeschlossenen ersten Halbleiterschalter (S11-S16) abhängig ist.

5. Verfahren nach einem vorhergehenden Anspruch, wobei aus der gemessenen Durchlassspannung (Vdsₘ) der Durchlasswiderstand (Rdsₘ) der ersten Schalteinheit (S1) bestimmt wird, wobei zum Bestimmen der Anzahl von geöffneten ersten Halbleiterschaltern (S11-S16) in der ersten Schalteinheit (S1) der Durchlasswiderstand (Rdsₘ) der ersten Schalteinheit (S1) mit mindestens einem von N vorbestimmten Widerstandsschwellwerten verglichen wird, die sich abhängig von der Anzahl von geöffneten ersten Halbleiterschaltern (S11-S16) unterscheiden, wobei M ≥ N ≥ 2, M die Anzahl von ersten Halbleiterschaltern (S11-S16) ist und N eine natürliche Zahl ist.

6. Verfahren nach Anspruch 5, wobei:
sich ein erster vorbestimmter Widerstandsschwellenwert (Rdsₜₕ₁) auf einen Durchlasswiderstand bezieht, der vorhanden ist, wenn sich einer der Vielzahl von ersten Halbleiterschaltern (S11-S16) in einem offenen Zustand befindet; und
sich ein N-ter vorbestimmter Widerstandsschwellenwert (Rds_{thN}) auf einen Durchlasswiderstand bezieht, der vorhanden ist, wenn sich N der Vielzahl von ersten Halbleiterschaltern (S11-S16) in einem offenen Zustand befinden;
wobei das Bestimmen der Anzahl von geöffneten ersten Halbleiterschaltern (S11-S16) in der ersten Schalteinheit (S1) ferner Folgendes umfasst:
Bestimmen (510), ob der Durchlasswiderstand (Rdsₘ) kleiner als der erste vorbestimmte Widerstandsschwellenwert (Rdsₜₕ₁) ist, und wenn ja, ferner Bestimmen (511), dass einer der ersten Halbleiterschalter (S11-S16) geöffnet ist;
wenn nicht, Bestimmen (513), ob der gemessene Durchlasswiderstand (Rdsₘ) kleiner als der zweite vorbestimmte Widerstandsschwellenwert (Rdsₜₕ₂) ist, und wenn ja, ferner Bestimmen (514), dass zwei der ersten Halbleiterschalter (S11-S16) geöffnet sind; und
solange die Anzahl von geöffneten ersten Halbleiterschaltern (S11-S16) nicht bestimmt worden ist, Wiederholen des Vergleichs (516, 519) bis zum N-ten vorbestimmten Widerstandsschwellenwert (Rds_{thN}), wobei mit dem N-ten vorbestimmten Widerstandsschwellenwert (Rds_{thN}) bestimmt wird, ob der Durchlasswiderstand (Rdsₘ) kleiner als der N-te vorbestimmte Widerstandsschwellenwert (Rds_{thN}) ist, und wenn ja, ferner bestimmt wird, dass N der ersten Halbleiterschalter (S11-S16) geöffnet sind.

7. Verfahren nach Anspruch 5, wobei der Durchlasswiderstand (Rdsₘ) der ersten Schalteinheit (S1) aus der gemessenen Durchlassspannung (Vdsₘ) unter Verwendung der folgenden Formel bestimmt wird: ${Rds}_{m} \left(t\right) = {Vds}_{m} \left(t\right) / {i}_{d} \left(t\right)$ wobei
RdSₘ (t) der Durchlasswiderstand der ersten Schalteinheit (S1);
VdSₘ (t) die Durchlassspannung über der ersten Schalteinheit (S1) ist; und
i_{d} (t) der Strom durch die erste Schalteinheit (S1) ist.

8. Verfahren nach einem vorhergehenden Anspruch, wobei eine vorbestimmte kontinuierliche Pulsfolge an einen Steueranschluss der weiteren Schalteinheit (SA, S4-S6) angelegt wird, wenn die weitere Schalteinheit (SA, S4-S6) in einer gepulsten Weise eingeschaltet wird.

9. Verfahren nach einem vorhergehenden Anspruch, wobei die ersten parallelen Halbleiterschalter (S11-S16) der ersten Schalteinheit (S1) durch einen einzelnen Gate-Treiber (111) gesteuert werden.

10. Stromversorgungssystem, umfassend:
einen Strombus (3, 4), der eine erste Spannungsschiene (3) und eine zweite Spannungsschiene (4) umfasst;
eine erste Schalteinheit (S1), die in der ersten Spannungsschiene (3) oder der zweiten Spannungsschiene (4) angeordnet ist, wobei die erste Schalteinheit (S1) eine Vielzahl von ersten Halbleiterschaltern (S11-S16) umfasst, die parallel angeordnet sind;
mindestens eine weitere Schalteinheit (SA, S4-S6), wobei die erste Schalteinheit (S1) und die weitere Schalteinheit (SA, S4-S6) so konfiguriert und in dem Stromversorgungssystem angeordnet sind, dass ein Strompfad durch sie verläuft, wenn beide eingeschaltet sind;
eine Spannungsmesseinheit (9), die dazu konfiguriert ist, die Durchlassspannung (Vdsₘ) über der Vielzahl von ersten Halbleiterschaltern (S11-S16) zu messen;
**gekennzeichnet durch**
ein Steuergerät (5), das zu Folgendem konfiguriert ist:
Ausschalten (301) der ersten parallelen Halbleiterschalter (S11-S16) der ersten Schalteinheit (S1) und Ausschalten der weiteren Schalteinheit (SA, S4-S6); Einschalten (302) der weiteren Schalteinheit (SA, S4-S6) in einer gepulsten Weise;
Bestimmen (303), ob ein Stromfluss zwischen den ausgeschalteten ersten parallelen Halbleiterschaltern (S11-S16) und der weiteren Schalteinheit (SA, S4-S6) vorliegt, wobei ein Stromfluss einen Kurzschlussfehlerzustand der ersten Schalteinheit (S1) angibt; und
wenn ein Stromfluss vorliegt, Bestimmen (304) der Anzahl von kurzgeschlossenen ersten Halbleiterschaltern (S11-S16) in der ersten Schalteinheit (S1) durch Messen (305) der Durchlassspannung (Vdsₘ) über der Vielzahl von ersten Halbleiterschaltern (S11-S16) mittels der Spannungsmesseinheit (9) und Vergleichen der gemessenen Durchlassspannung (Vdsₘ) mit mindestens einer von N vorbestimmten Schwellenspannungen über der Vielzahl von ersten Halbleiterschaltern (S11-S16), die sich abhängig von der Anzahl von kurzgeschlossenen ersten Halbleiterschaltern (S11-S16) unterscheiden, wobei M ≥ N ≥ 2, M die Anzahl der ersten Halbleiterschalter (S11-S16) ist und N eine natürliche Zahl ist.

11. Stromversorgungssystem nach Anspruch 10, wobei:
- sich eine erste vorbestimmte Schwellenspannung (Vdsₜₕ₁) auf eine Durchlassspannung über der Vielzahl von ersten Halbleiterschaltern (S11-S16) bezieht, die vorhanden ist, wenn sich einer der Vielzahl von ersten Halbleiterschaltern (S11-S16) in einem kurzgeschlossenen Zustand befindet; und
- sich eine N-te vorbestimmte Schwellenspannung (Vds_{thN}) auf eine Durchlassspannung über der Vielzahl von ersten Halbleiterschaltern (S11-S16) bezieht, die vorhanden ist, wenn sich N der Vielzahl von ersten Halbleiterschaltern (S11-S16) in einem kurzgeschlossenen Zustand befinden;
wobei das Steuergerät (5) dazu konfiguriert ist, die Anzahl von kurzgeschlossenen ersten Halbleiterschaltern (S11-S16) in der ersten Schalteinheit (S1) durch Folgendes zu bestimmen:
Bestimmen (411), ob die durch die Spannungsmesseinheit (9) gemessene Durchlassspannung (Vdsₘ) kleiner als die erste vorbestimmte Schwellenspannung (Vdsₜₕ₁) ist, und wenn ja, ferner Bestimmen (412), dass einer der ersten Halbleiterschalter (S11- S16) kurzgeschlossen ist;
wenn nicht, Bestimmen (413), ob die gemessene Durchlassspannung (Vdsₘ) kleiner als die zweite vorbestimmte Schwellenspannung (Vdsₜₕ₂) ist, und wenn ja, ferner Bestimmen (414), dass zwei der ersten Halbleiterschalter (S11-S16) kurzgeschlossen sind; und
solange die Anzahl von kurzgeschlossenen ersten Halbleiterschaltern (S11-S16) nicht bestimmt worden ist, Wiederholen des Vergleichs (415, 417) bis zur N-ten vorbestimmten Schwellenspannung (Vds_{thN}), wobei mit der N-ten vorbestimmten Schwellenspannung (Vds_{thN}) bestimmt wird (417), ob die gemessene Durchlassspannung (Vdsₘ) kleiner als die N-te vorbestimmte Schwellenspannung (Vds_{thN}) ist, und wenn ja, ferner bestimmt wird (418), dass N der ersten Halbleiterschalter (S11-S16) kurzgeschlossen sind.

12. Stromversorgungssystem nach Anspruch 10 oder 11, wobei das Steuergerät (5) dazu konfiguriert ist, durch Folgendes zu bestimmen, ob ein Stromfluss zwischen den ausgeschalteten ersten parallelen Halbleiterschaltern (S11-S16) und der weiteren Schalteinheit (SA, S4-S6) vorliegt:
Einschalten (404) der ersten parallelen Halbleiterschalter (S11-S16) der ersten Schalteinheit (S1) und Einschalten (404) der weiteren Schalteinheit (SA, S4-S6) in einer gepulsten Weise;
Messen (405) der Durchlassspannung (Vdsₘ) über der Vielzahl von ersten Halbleiterschaltern (S11-S16) mittels der Spannungsmesseinheit (9) während des Anlegens von Impulsen;
Vergleichen (406) der gemessenen Durchlassspannung (Vdsₘ) der Vielzahl von ersten Halbleiterschaltern (S11-S16) mit einer vorbestimmten Schwellenspannung in fehlerfreiem Zustand (Vdsₜₕ), wobei sich die vorbestimmte Schwellenspannung in fehlerfreiem Zustand (Vdsₜₕ) auf eine Durchlassspannung bezieht, die vorhanden ist, wenn sich alle der Vielzahl von ersten Halbleiterschaltern (S11-S16) in einem fehlerfreien Zustand befinden; und
Bestimmen (406), ob die gemessene Durchlassspannung (Vdsₘ) größer als die vorbestimmte Schwellenspannung in fehlerfreiem Zustand (Vdsₜₕ) ist.

13. Stromversorgungssystem nach einem der Ansprüche 10 bis 12, wobei das Steuergerät (5) ferner dazu konfiguriert ist, das System so zu steuern, dass ein Strom nur durch die kurzgeschlossenen ersten Halbleiterschalter (S11-S16) der ersten Schalteinheit (S1) und durch die weitere Schalteinheit geleitet wird, um die kurzgeschlossenen ersten Halbleiterschalter (S11-S16) oder Reihensicherungen zu verbrennen, die jeweils in Reihe mit den kurzgeschlossenen Halbleiterschaltern (S11-S16) angeordnet sind, wobei der Strom von der Anzahl der kurzgeschlossenen ersten Halbleiterschalter (S11-S16) abhängig ist.

14. Stromversorgungssystem nach einem der Ansprüche 10 bis 13, wobei das Steuergerät (5) ferner dazu konfiguriert ist, aus der gemessenen Durchlassspannung (Vdsₘ) den Durchlasswiderstand (Rdsₘ) der ersten Schalteinheit (S1) zu bestimmen, wobei zum Bestimmen der Anzahl von geöffneten ersten Halbleiterschaltern (S11-S16) in der ersten Schalteinheit (S1) das Steuergerät (5) dazu konfiguriert ist, den Durchlasswiderstand (Rdsₘ) der ersten Schalteinheit (S1) mit mindestens einem von N vorbestimmten Widerstandsschwellwerten zu vergleichen, die sich abhängig von der Anzahl von geöffneten ersten Halbleiterschaltern (S11-S16) unterscheiden, wobei M ≥ N ≥ 2, M die Anzahl von ersten Halbleiterschaltern (S11-S16) ist und N eine natürliche Zahl ist.

15. Stromversorgungssystem nach Anspruch 14, wobei:
sich ein erster vorbestimmter Widerstandsschwellenwert (Rdsₜₕ₁) auf einen Durchlasswiderstand bezieht, der vorhanden ist, wenn sich einer der Vielzahl von ersten Halbleiterschaltern (S11-S16) in einem geöffneten Zustand befindet; und
sich ein N-ter vorbestimmter Widerstandsschwellenwert (Rds_{thN}) auf einen Durchlasswiderstand bezieht, der vorhanden ist, wenn sich N der Vielzahl von ersten Halbleiterschaltern (S11-S16) in geöffnetem Zustand befinden;
wobei das Steuergerät (5) dazu konfiguriert ist, die Anzahl von geöffneten ersten Halbleiterschaltern (S11-S16) in der ersten Schalteinheit (S1) durch Folgendes zu bestimmen:
Bestimmen (510), ob der Durchlasswiderstand (Rdsₘ) kleiner als der erste vorbestimmte Widerstandsschwellenwert (Rdsₜₕ₁) ist, und wenn ja, ferner Bestimmen (511), dass einer der ersten Halbleiterschalter (S11-S16) geöffnet ist,
wenn nicht, Bestimmen (513), ob der gemessene Durchlasswiderstand (Rdsₘ) kleiner als der zweite vorbestimmte Widerstandsschwellenwert (Rdsₜₕ₂) ist, und wenn ja, ferner Bestimmen (514), dass zwei der ersten Halbleiterschalter (S11-S16) geöffnet sind; und
solange die Anzahl von geöffneten ersten Halbleiterschaltern (S11-S16) nicht bestimmt worden ist, Wiederholen des Vergleichs (516, 519) bis zum N-ten vorbestimmten Widerstandsschwellenwert (Rds_{thN}), wobei mit dem N-ten vorbestimmten Widerstandsschwellenwert (Rds_{thN}) bestimmt wird, ob der Durchlasswiderstand (Rdsₘ) kleiner als der N-te vorbestimmte Widerstandsschwellenwert (Rds_{thN}) ist, und wenn ja, ferner bestimmt wird, dass N der ersten Halbleiterschalter (S11-S16) geöffnet sind.

## Revendications

1. Procédé permettant la détection de l'état de santé d'une première unité de commutation (S1) d'un système de puissance, ladite première unité de commutation (S1) comprenant une pluralité de premiers commutateurs à semi-conducteur (S11-S16) agencés en parallèle, ledit système de puissance comprenant en outre au moins une unité de commutation supplémentaire (SA, S4-S6), et ladite première unité de commutation (S1) et ladite unité de commutation supplémentaire (SA, S4-S6) étant agencées dans un trajet de courant de sorte qu'un courant les traverse lorsque les deux sont à l'état passant, et ledit procédé comprenant les étapes de :
mise à l'état non passant (301) des premiers commutateurs à semi-conducteurs parallèles (S11-S16) de la première unité de commutation (S1) et mise à l'état non passant de l'unité de commutation supplémentaire (SA, S4-S6) ;
**caractérisé par** la mise à l'état passant (302) de l'unité de commutation supplémentaire (SA, S4-S6) de manière pulsée :
la détermination (303) pour savoir si un flux de courant est présent entre les premiers commutateurs à semi-conducteur parallèles à l'état non passant (S11-S16) et l'unité de commutation supplémentaire (SA, S4-S6), un flux de courant indiquant un état de défaillance de court-circuit de la première unité de commutation (S1) ; et si un flux de courant est présent, la détermination (304) du nombre de premiers commutateurs à semi-conducteur en court-circuit (S11-S16) dans la première unité de commutation (S1) en mesurant (305) la tension à l'état passant (Vdsₘ) aux bornes de la pluralité de premiers commutateurs à semi-conducteur (S11-S16) et en comparant la tension à l'état passant mesurée (Vdsₘ) à au moins l'une des N tensions de seuil prédéfinies sur la pluralité de premiers commutateurs à semi-conducteur (S11-S16) qui diffèrent en fonction du nombre de premiers commutateurs à semi-conducteur en court-circuit (S11-S16), M > N > 2, dans laquelle M est le nombre de premiers commutateurs à semi-conducteur (S11-S16) et N est un nombre naturel.

2. Procédé de la revendication 1,
une première tension de seuil prédéfinie (Vdsₜₕ₁) référant à une tension à l'état passant aux bornes la pluralité de premiers commutateurs à semi-conducteur (S11-S16) présente lorsque l'un de la pluralité de premiers commutateurs à semi-conducteur (S11-S16) est dans un état de court-circuit ; et
une N-ième tension de seuil prédéfinie (Vds_{thN}) référant à une tension à l'état passant aux bornes de la pluralité de premiers commutateurs à semi-conducteur (S11-S16) présente lorsque N commutateurs à semi-conducteur de la pluralité de premiers commutateurs à semi-conducteur (S11-S16) sont dans un état de court-circuit ;
ladite détermination du nombre de premiers commutateurs à semi-conducteur en court-circuit (S11-S16) dans la première unité de commutation comprenant en outre :
la détermination (411) pour savoir si la tension à l'état passant mesurée (Vdsₘ) est inférieure à la première tension de seuil prédéfinie (Vdsₜₕ₁) et, si c'est le cas, la détermination en outre (412) que l'un des premiers commutateurs à semi-conducteur (S11-S16) est en court-circuit ;
si ce n'est pas le cas, la détermination (413) pour savoir si la tension à l'état passant mesurée (Vdsₘ) est inférieure à la seconde tension de seuil prédéfinie (Vdsₜₕ₂) et, si c'est le cas, la détermination (414) en outre que deux des premiers commutateurs à semi-conducteur (S11-S16) sont en court-circuit ; et
tant que le nombre de premiers commutateurs à semi-conducteur en court-circuit (S11-S16) n'a pas été déterminé, la répétition de la comparaison (415, 417) jusqu'à la N-ième tension de seuil prédéfinie (Vds_{thN}), avec la N-ième tension de seuil prédéfinie (Vds_{thN}), la détermination (417) pour savoir si la tension à l'état passant mesurée (Vdsₘ) est inférieure à la N-ième tension de seuil prédéfinie (Vds_{thN}) et, si c'est le cas, la détermination (418) que N commutateurs à semi-conducteur des premiers commutateurs à semi-conducteur (S11-S16) sont en court-circuit.

3. Procédé de la revendication 1 ou 2, ladite détermination pour savoir si un flux de courant est présent entre les premiers commutateurs à semi-conducteur parallèles à l'état non passant (S11-S16) et l'unité de commutation supplémentaire (SA, S4-S6) comprenant :
la mise à l'état passant (404) des premiers commutateurs à semi-conducteur parallèles (S11-S16) de la première unité de commutation (S1) et la mise à l'état passant (404) de l'unité de commutation supplémentaire (SA, S4-S6) de manière pulsée ;
la mesure (405) de la tension à l'état passant (Vdsₘ) sur la pluralité de premiers commutateurs à semi-conducteur (S11-S16) durant l'application d'impulsions ;
la comparaison (406) de la tension à l'état passant mesurée (Vdsₘ) de la pluralité de premiers commutateurs à semi-conducteur (S11-S16) à une tension de seuil d'état sain prédéfinie (Vdsₜₕ), ladite tension de seuil d'état sain prédéfinie (Vdsₜₕ) référant à une tension à l'état passant présente lorsque tous ceux de la pluralité de premiers commutateurs à semi-conducteur (S11-S16) sont dans un état sain ; et
la détermination (406) pour savoir si la tension à l'état passant mesurée (Vdsₘ) est supérieure à la tension de seuil d'état sain prédéfinie (Vdsₜₕ).

4. Procédé d'une quelconque revendication précédente, un courant est guidé à travers uniquement les premiers commutateurs à semi-conducteur en court-circuit (S11-S16) de la première unité de commutation (S1) et à travers l'unité de commutation supplémentaire (SA, S4-S6) pour brûler les premiers commutateurs à semi-conducteur en court-circuit (S11-S16) ou les fusibles série respectivement agencés en série avec les commutateurs à semi-conducteur en court-circuit (S11-S16), ledit courant étant dépendant du nombre de premiers commutateurs à semi-conducteur en court-circuit (S11-S16).

5. Procédé d'une quelconque revendication précédente, à partir de la tension à l'état passant mesurée (Vdsₘ), ladite résistance à l'état passant (Rdsₘ) de la première unité de commutation (S1) étant déterminée, pour déterminer le nombre de premiers commutateurs à semi-conducteur en circuit ouvert (S11-S16) dans la première unité de commutation (S1), ladite résistance à l'état passant (Rdsₘ) de la première unité de commutation (S1) étant comparée à au moins l'une des N valeurs de seuil de résistance prédéfinies qui diffèrent en fonction du nombre de premiers commutateurs à semi-conducteur en circuit ouvert (S11-S16), M > N > 2, dans laquelle M est le nombre de premiers commutateurs à semi-conducteur (S11-S16) et N est un nombre naturel.

6. Procédé de la revendication 5,
une première valeur de seuil de résistance prédéfinie (Rdsₜₕ₁) référant à une résistance à l'état passant présente lorsque l'un de la pluralité de premiers commutateurs à semi-conducteur (S11-S16) est dans un état de circuit ouvert ; et
une N-ième valeur de seuil de résistance prédéfinie (Rds_{thN}) référant à une résistance à l'état passant présente lorsque N commutateurs à semi-conducteur de la pluralité de premiers commutateurs à semi-conducteur (S11-S16) sont dans un état de circuit ouvert ; et
ladite détermination du nombre de premiers commutateurs à semi-conducteur en circuit ouvert (S11-S16) dans la première unité de commutation (S1) comprenant en outre :
la détermination (510) pour savoir si la résistance à l'état passant (Rdsₘ) est inférieure à la première valeur de seuil de résistance prédéfinie (Rdsₜₕ₁) et, si c'est le cas, la détermination en outre (511) que l'un des premiers commutateurs à semi-conducteur (S11-S16) est en circuit ouvert ;
si ce n'est pas le cas, la détermination (513) pour savoir si la résistance à l'état passant mesurée (Rdsₘ) est inférieure à la seconde valeur de seuil de résistance prédéfinie (Rdsₜₕ₂) et, si c'est le cas, la détermination en outre (514) que deux des premiers commutateurs à semi-conducteur (S11-S16) sont en circuit ouvert ; et
tant que le nombre de premiers commutateurs à semi-conducteur en circuit ouvert (S11-S16) n'a pas été déterminé, la répétition de la comparaison (516, 519) jusqu'à la N-ième valeur de seuil de résistance prédéfinie (Rds_{thN}), avec la N-ième valeur de seuil de résistance prédéfinie (Rds_{thN}), la détermination pour savoir si la résistance à l'état passant (Rdsₘ) est inférieure à la N-ième valeur de seuil de résistance prédéfinie (Rds_{thN}) et, si c'est le cas, la détermination en outre que N commutateurs à semi-conducteur des premiers commutateurs à semi-conducteur (S11-S16) sont en circuit ouvert.

7. Procédé de la revendication 5, ladite résistance à l'état passant (Rdsₘ) de la première unité de commutation (S1) étant déterminée à partir de la tension à l'état passant mesurée (Vdsₘ) à l'aide de la formule ${Rds}_{m} \left(t\right) = {Vds}_{m} \left(t\right) / {i}_{d} \left(t\right)$ dans laquelle
Rdsₘ(t) est la résistance à l'état passant de la première unité de commutation (S1) ;
Vdsₘ(t) est la tension à l'état passant sur la première unité de commutation (S1) ; et
i_{d}(t) est le courant traversant la première unité de commutation (S1).

8. Procédé d'une quelconque revendication précédente, un flux continu prédéfini d'impulsions étant appliqué à une borne de commande de l'unité de commutation supplémentaire (SA, S4-S6) lors de la mise à l'état passant de l'unité de commutation supplémentaire (SA, S4-S6) de manière pulsée.

9. Procédé d'une quelconque revendication précédente, lesdits premiers commutateurs à semi-conducteur parallèles (S11-S16) de la première unité de commutation (S1) étant commandés par un seul circuit d'attaque de grille (111).

10. Système de puissance comprenant :
un bus de puissance (3, 4) comprenant un premier rail de tension (3) et un second rail de tension (4) ;
une première unité de commutation (S1) agencée dans le premier rail de tension (3) ou le second rail de tension (4), ladite première unité de commutation (S1) comprenant une pluralité de premiers commutateurs à semi-conducteur (S11-S16) agencés en parallèle ;
au moins une unité de commutation supplémentaire (SA, S4-6), ladite première unité de commutation (S1) et ladite unité de commutation supplémentaire (SA, S4-S6) étant configurées et agencées dans le système de puissance de sorte qu'un trajet de courant les traverse lorsque les deux sont à l'état passant ;
une unité de mesure de tension (9) configurée pour mesurer la tension à l'état passant (Vdsₘ) aux bornes de la pluralité de premiers commutateurs à semi-conducteur (S11-S16) ; **caractérisé par**
un dispositif de commande (5) configuré pour :
mettre à l'état non passant (301) des premiers commutateurs à semi-conducteur parallèles (S11-S16) de la première unité de commutation (S1) et mettre à l'état non passant l'unité de commutation supplémentaire (SA, S4-S6) ; mettre à l'état passant (302) l'unité de commutation supplémentaire (SA, S4-S6) d'une manière pulsée ;
déterminer (303) si un flux de courant est présent entre les premiers commutateurs à semi-conducteur parallèles à l'état non passant (S11-S16) et l'unité de commutation supplémentaire (SA, S4-S6), un flux de courant indiquant une condition de défaillance de court-circuit de la première unité de commutation (S1) ; et
si un flux de courant est présent, déterminer (304) le nombre de premiers commutateurs à semi-conducteur en court-circuit (S11-S16) dans la première unité de commutation (S1) en mesurant (305) la tension à l'état passant (Vdsₘ) aux bornes de la pluralité de premiers commutateurs à semi-conducteur (S11-S16) au moyen de l'unité de mesure de tension (9) et en comparant la tension à l'état passant mesurée (Vdsₘ) à au moins l'une des N tensions de seuil prédéfinies aux bornes de la pluralité de premiers commutateurs à semi-conducteur (S11-S16) qui diffèrent en fonction du nombre de premiers commutateurs à semi-conducteur en court-circuit (S11-S16), M > N > 2, dans laquelle M est le nombre de premiers commutateurs à semi-conducteur (S11-S16) et N est un nombre naturel.

11. Système de puissance de la revendication 10,
- une première tension de seuil prédéfinie (Vdsₜₕ₁) référant à une tension à l'état passant aux bornes la pluralité de premiers commutateurs à semi-conducteur (S11-S16) présente lorsque l'un de la pluralité de premiers commutateurs à semi-conducteur (S11-S16) est dans un état de court-circuit ; et - une N-ième tension de seuil prédéfinie (Vds_{thN}) référant à une tension à l'état passant aux bornes la pluralité de premiers commutateurs à semi-conducteur (S11-S16) présente lorsque N commutateurs à semi-conducteur de la pluralité de premiers commutateurs à semi-conducteur (S11-S16) sont dans un état de court-circuit ;
ledit dispositif de commande (5) étant configuré pour déterminer le nombre de premiers commutateurs à semi-conducteur en court-circuit (S11-S16) dans la première unité de commutation (S1) par :
la détermination (411) pour savoir si la tension à l'état passant (Vdsₘ) mesurée par l'unité de mesure de tension (9) est inférieure à la première tension de seuil prédéfinie (Vdsₜₕ₁) et, si c'est le cas, la détermination (412) en outre que l'un des premiers commutateurs à semi-conducteur (S11-S16) est en court-circuit ;
si ce n'est pas le cas, la détermination (413) pour savoir si la tension à l'état passant mesurée (Vdsₘ) est inférieure à la seconde tension de seuil prédéfinie (Vdsₜₕ₂) et, si c'est le cas, la détermination en outre (414) que deux des premiers commutateurs à semi-conducteur (S11-S16) sont en court-circuit ; et
tant que le nombre de premiers commutateurs à semi-conducteur en court-circuit (S11-S16) n'a pas été déterminé, la répétition de la comparaison (415, 417) jusqu'à la N-ième tension de seuil prédéfinie (Vds_{thN}), avec la N-ième tension de seuil prédéfinie (Vds_{thN}), la détermination (417) pour savoir si la tension à l'état passant mesurée (Vdsₘ) est inférieure à la N-ième tension de seuil prédéfinie (Vds_{thN}) et, si c'est le cas, la détermination (418) que N commutateurs à semi-conducteur des premiers commutateurs à semi-conducteur (S11-S16) sont en court-circuit.

12. Système de puissance de la revendication 10 ou 11, ledit dispositif de commande (5) étant configuré pour déterminer si un flux de courant est présent entre les premiers commutateurs à semi-conducteur parallèles à l'état non passant (S11-S16) et l'unité de commutation supplémentaire (SA, S4-S6) par :
la mise à l'état passant (404) des premiers commutateurs à semi-conducteur parallèles (S11-S16) de la première unité de commutation (S1) et la mise à l'état passant (404) de l'unité de commutation supplémentaire (SA, S4-S6) de manière pulsée ;
la mesure (405) de la tension à l'état passant (Vdsₘ) sur la pluralité de premiers commutateurs à semi-conducteur (S11-S16) au moyen de l'unité de mesure de tension (9) durant l'application d'impulsions ;
la comparaison (406) de la tension à l'état passant mesurée (Vdsₘ) de la pluralité de premiers commutateurs à semi-conducteur (S11-S16) à une tension de seuil d'état sain prédéfinie (Vdsₜₕ), ladite tension de seuil d'état sain prédéfinie (Vdsₜₕ) référant à une tension à l'état passant présente lorsque tous ceux de la pluralité de premiers commutateurs à semi-conducteur (S11-S16) sont dans un état sain ; et
la détermination (406) pour savoir si la tension à l'état passant mesurée (Vdsₘ) est supérieure à la tension de seuil d'état sain prédéfinie (Vdsₜₕ).

13. Système de puissance de l'une quelconque des revendications 10 à 12, ledit dispositif de commande (5) étant en outre configuré pour commander le système de sorte qu'un courant est guidé à travers uniquement les premiers commutateurs à semi-conducteur en court-circuit (S11-S16) de la première unité de commutation (S1) et à travers l'unité de commutation supplémentaire pour brûler les premiers commutateurs à semi-conducteur en court-circuit (S11-S16) ou les fusibles série respectivement agencés en série avec les commutateurs à semi-conducteur en court-circuit (S11-S16), ledit courant étant dépendant du nombre de premiers commutateurs à semi-conducteur en court-circuit (S11-S16).

14. Système de puissance de l'une quelconque des revendications 10 à 13, ledit dispositif de commande (5) étant en outre configuré pour déterminer à partir de la tension à l'état passant mesurée (Vdsₘ) la résistance à l'état passant (Rdsₘ) de la première unité de commutation (S1), pour déterminer le nombre de premiers commutateurs à semi-conducteur en circuit ouvert (S11-S16) dans la première unité de commutation (S1), ledit dispositif de commande (5) étant configuré pour comparer la résistance à l'état passant (Rdsₘ) de la première unité de commutation (S1) à au moins l'une des N valeurs de seuil de résistance prédéfinies qui diffèrent en fonction du nombre de premiers commutateurs à semi-conducteur en circuit ouvert (S11-S16), M > N > 2, dans laquelle M est le nombre de premiers commutateurs à semi-conducteur (S11-S16) et N est un nombre naturel.

15. Système de puissance de la revendication 14,
une première valeur de seuil de résistance prédéfinie (Rdsₜₕ₁) référant à une résistance à l'état passant présente lorsque l'un de la pluralité de premiers commutateurs à semi-conducteur (S11-S16) est dans un état en circuit ouvert ; et
une N-ième valeur de seuil de résistance prédéfinie (Rds_{thN}) référant à une résistance à l'état passant présente lorsque N commutateurs à semi-conducteur de la pluralité de premiers commutateurs à semi-conducteur (S11-S16) sont dans un état en circuit ouvert ; et
ledit dispositif de commande (5) étant configuré pour déterminer le nombre de premiers commutateurs à semi-conducteur en circuit ouvert (S11-S16) dans la première unité de commutation (S1) par :
la détermination (510) pour savoir si la résistance à l'état passant (Rdsₘ) est inférieure à la première valeur de seuil de résistance prédéfinie (Rdsₜₕ₁) et, si c'est le cas, la détermination (511) en outre que l'un des premiers commutateurs à semi-conducteur (S11-S16) est en circuit ouvert,
si ce n'est pas le cas, la détermination (513) pour savoir si la résistance à l'état passant mesurée (Rdsₘ) est inférieure à la seconde valeur de seuil de résistance prédéfinie (Rdsₜₕ₂) et, si c'est le cas, la détermination en outre (514) que deux des premiers commutateurs à semi-conducteur (S11-S16) sont en circuit ouvert ; et
tant que le nombre de premiers commutateurs à semi-conducteur en circuit ouvert (S11-S16) n'a pas été déterminé, la répétition de la comparaison (516, 519) jusqu'à la N-ième valeur de seuil de résistance prédéfinie (Rds_{thN}), avec la N-ième valeur de seuil de résistance prédéfinie (Rds_{thN}), la détermination pour savoir si la résistance à l'état passant (Rdsₘ) est inférieure à la N-ième valeur de seuil de résistance prédéfinie (Rds_{thN}) et, si c'est le cas, la détermination en outre que N commutateurs à semi-conducteur des premiers commutateurs à semi-conducteur (S11-S16) sont en circuit ouvert.
